(19) Europäisches Patentamt / European Patent Office / Office européen des brevets

(11) **EP 4 198 317 B1**

(12) **EUROPÄISCHE PATENTSCHRIFT**

(45) Veröffentlichungstag und Bekanntmachung des Hinweises auf die Patenterteilung:
**28.02.2024 Patentblatt 2024/09**

(21) Anmeldenummer: **22196967.8**

(22) Anmeldetag: **21.09.2022**

(51) Internationale Patentklassifikation (IPC):
**F04D 15/00** *(2006.01)*

(52) Gemeinsame Patentklassifikation (CPC):
**F04D 15/0066; F04D 15/0088;** F05D 2260/81; F05D 2260/82

(54) **VERFAHREN ZUR FÖRDERSTROM- UND/ ODER FÖRDERHÖHENBESTIMMUNG**

METHOD FOR DETERMINING THE FLOW RATE AND/OR THE DISCHARGE HEAD

PROCÉDÉ DE DÉTERMINATION DE LA HAUTEUR DE DÉBIT ET/OU DE REFOULEMENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.12.2021 LU 501040**

(43) Veröffentlichungstag der Anmeldung:
**21.06.2023 Patentblatt 2023/25**

(73) Patentinhaber: **WILO SE**
**44263 Dortmund (DE)**

(72) Erfinder: **Fiedler, Jens Olav**
**44263 Dortmund (DE)**

(74) Vertreter: **Cohausz Hannig Borkowski Wißgott Patentanwaltskanzlei GbR**
**Schumannstraße 97-99**
**40237 Düsseldorf (DE)**

(56) Entgegenhaltungen:
**DE-A1-102014 004 336      DE-A1-102014 016 421**
**DE-A1-102016 208 211      US-A1- 2017 184 429**

**Beschreibung**

Die Erfindung betrifft ein Verfahren zur Ermittlung des Förderstroms und/ oder der Förderhöhe eines in einem hydraulischen Rohrleitungsnetzwerk angeordneten, drehzahlgeregelten Kreiselpumpenaggregats aus einer in dem Kreiselpumpenaggregat erfassbaren Systemantwort des Rohrleitungsnetzwerks auf eine periodische Modulation der Drehzahl und/ oder des Drehmoments des Kreiselpumpenaggregats. Des Weiteren betrifft die Erfindung ein Kreiselpumpenaggregat umfassend eine Kreiselpumpe, einen diese antreibenden Elektromotor und eine Steuerungselektronik zur Steuerung und/ oder Regelung des Elektromotors, die zur Ausführung des Verfahrens eingerichtet ist.

Aus der deutschen Patentanmeldung DE 102014004336 A1 ist es bekannt, ein Rohrleitungsnetzwerk durch periodische Modulation der Solldrehzahl oder des Drehmoments eines in dem Rohrleitungsnetzwerk angeordneten Kreiselpumpenaggregats anzuregen, um eine Systemantwort zu provozieren, die sich wiederum in einer auswertbaren Reaktion des Kreiselpumpenaggregats niederschlägt, beispielswiese in Form einer Änderung der elektrischen Leistungsaufnahme oder des notwendigen Drehmoments, um die (modulierte) Solldrehzahl beizubehalten. Die Systemantwort (Höhe, Form, Phase, Verzögerung) ist abhängig von der sogenannten "hydraulischen Impedanz" des Rohrleitungsnetzwerks. Aus der Reaktion des Kreiselpumpenaggregats hierauf kann dieses seinen Förderstrom ermitteln.

Untersuchungen haben gezeigt, dass dieses Verfahren eine vergleichsweise große Modulationsamplitude benötigt, um ein ausreichend hohes Signal- Rauschverhältnis im auszuwertenden Nutzsignal zu erhalten und somit eine zuverlässige Bestimmung des Volumenstroms und/ oder der Förderhöhe zu ermöglichen. Demgegenüber ist das Rauschen im Nutzsignal bei geringer Modulationsamplitude vergleichsweise groß und verschlechtert dadurch die Genauigkeit der Volumenstrombestimmung. Eine große Modulationsamplitude führt allerdings zu Strömungsgeräuschen, die in Rohrleitungsnetzwerken wie Zentralheizungsanlagen oder Kühlungsanlagen unerwünscht sind.

Weitere relevante Dokumente sind US 2017/184429 A1, DE 10 2014 016421 A1 und DE 10 2016 208211 A1.

Aufgabe der vorliegenden Erfindung ist es, das im Stand der Technik bekannte Verfahren zu verbessern, insbesondere das Rauschen im Nutzsignal trotz vergleichsweise geringer Anregungsamplitude zu reduzieren und gleichzeitig die Genauigkeit der Ermittlung des Förderstroms zu erhöhen.

Diese Aufgabe wird durch ein Verfahren mit den Merkmalen des Anspruchs 1 sowie durch ein Kreiselpumpenaggregat nach Anspruch 15 gelöst. Vorteilhafte Weiterbildungen sind in den Unteransprüchen angegeben und werden nachfolgend erläutert.

Erfindungsgemäß wird vorgeschlagen, eine Bezugsdrehzahl oder ein Drehmoment des Kreiselpumpenaggregats mit einem periodischen Anregungssignal einer bestimmten Anregungsfrequenz zu beaufschlagen, um eine modulierte Solldrehzahl zu erreichen, und anschließend folgende Schritte auszuführen:

a. Bestimmung und Einstellung eines zur Erreichung der modulierten Solldrehzahl erforderlichen Drehmoments oder Einstellung des modulierten Drehmoments,
b. Bestimmung der Istdrehzahl des Pumpenaggregats,
c. Berechnung einer Modelldrehzahl mit Hilfe eines das Verhalten des Kreiselpumpenaggregats innerhalb eines hydraulischen Systems nachbildenden, mathematischen Pumpen-Motor-Modells,
d. Berechnung wenigstens eines Störungssignals aus einer Abweichung der Modelldrehzahl von der Istdrehzahl des Kreiselpumpenaggregats,
e. Bestimmung wenigstens eines Korrektursignals durch Integration des Produkts aus dem Störungssignal und einem Sinus- oder Cosinussignal mit dem Einfachen oder einem Vielfachen der Anregungsfrequenz über wenigstens eine Periode des Anregungssignals,
f. Anpassung wenigstens eines Modellparameters des Pumpen-Motor-Modells in Abhängigkeit des Korrektursignals und
g. Berechnung des Förderstroms und/ oder der Förderhöhe mit Hilfe des angepassten Pumpen-Motor-Modells.

Des Weiteren wird ein Kreiselpumpenaggregat mit einer Kreiselpumpe, einem diese antreibenden Elektromotor und einer Steuerungselektronik zur Steuerung und/ oder Regelung des Elektromotors vorgeschlagen, wobei die Steuerungselektronik eingerichtet ist, das Verfahren gemäß der Erfindung auszuführen.

Das vorgenannte Verfahren hat zahlreiche Vorteile. Zum einen verbessert es die Genauigkeit der Förderstrom- und/ oder Förderhöhenermittlung, da Störeinflüssen auf das aus dem Kreiselpumpenaggregat und dem angeschlossenen hydraulischen Rohrleitungsnetzwerk gebildete System entgegengewirkt und dadurch das Rauschen im ermittelten Förderstrom- und/ oder Förderhöhensignal reduziert wird. Das Signal muss daher weniger stark gefiltert werden, so dass eine schnellere Reaktion des Kreiselpumpenaggregats auf Systemzustandsänderungen oder Störungen im hydraulischen Rohrleitungsnetzwerk erfolgen kann. Ferner kann bei dem periodischen Anregungssignal eine geringere Anregungsamplitude als im Stand der Technik verwendet und somit Geräusche reduziert werden. Infolge der Anpassung des/ oder der Modellparameter(s) im Betrieb des Pumpenaggregats werden außerdem etwaige Modellierungsungenauigkeiten im Pumpen-Motor-Modell kompensiert, die auf eine Streuung der Modellparameter in der Serienherstellung und/ oder auf den alterungsbedingten Verschleiß, z.B. der Lager der Kreiselpumpe, zurückgehen können.

Durch die wiederholte Anpassung des/ oder der Modellparameter(s) ist das Pumpen-Motor-Modell dynamisch. Dies erlaubt unter anderem, Alterungserscheinungen am Kreiselpumpenaggregat zu erkennen und einen dadurch bedingten, mit der Zeit zunehmenden Fehler im Pumpen-Motor-Modell zu kompensieren. Auf diese Weise wird die Genauigkeit der Förderstrom- und/ oder Förderhöhenermittlung über die gesamte Betriebszeit des Pumpenaggregats konstant hoch gehalten. Zusätzlich können Ablagerungen auf dem Laufrad, z.B. von Eisenoxid erkannt werden, allgemein unter der Bezeichnung "Verockerung" bekannt, womit ein frühzeitiger Hinweis auf eine notwendige Wartung, insbesondere des Gesamtsystems, gegeben werden kann.

Geeigneterweise umfasst das Pumpen-Motor-Modell wenigstens eine erste Gleichung, die eine Berechnung des Förderstroms ermöglicht, und eine zweite Gleichung, die eine Berechnung der Modelldrehzahl ermöglicht. Geeigneterweise werden diese beiden Gleichungen wiederholt zyklisch ausgewertet. Signaltechnisch kann diese Berechnung parallel erfolgen.

Beispielsweise kann die erste Gleichung eine Volumenstromgleichung in Integralform sein. Sie basiert vorzugsweise auf einer hydraulischen Differentialgleichung, die insbesondere eine Förderhöhen- bzw. Druckbilanz (Förderhöhe und Druck sind proportional) beschreibt und in die Integralform umgeformt ist, um den Förderstrom auf einfache Weise berechnen zu können.

Weiter bevorzugt kann die zweite Gleichung eine Geschwindigkeitsgleichung in Integralform sein. Diese basiert vorzugsweise auf einer hydromechanischen Differentialgleichung, die insbesondere eine Drehmomentbilanz beschreibt und in die Integralform umgeformt ist, um die Modelldrehzahl auf einfache Weise berechnen zu können.

Die erste Gleichung bzw. Volumenstromgleichung kann beispielsweise in der folgenden Integralform verwendet werden:

$$\text{GI1:} \quad Q_{mdl} = \frac{1}{L_{hyd}} \int_0^t \left( (a\omega^2 - bQ_{mdl}\omega - cQ_{mdl}^2) - R_{hyd}Q_{mdl}^2 - H_{static} \right) dt$$

wobei

$Q_{mdl}$    der zu ermittelnde Förderstrom der Kreiselpumpe,
$\omega$    eine Drehzahl bzw. Drehfrequenz der Kreiselpumpe ($\omega = 2\pi n$),
$a, b, c$    Parameter sind, die das hydraulische Pumpenkennfeld ($H(Q, \omega)$) anhand von Pumpenkurven beschreiben,
$R_{hyd}$    der hydraulische Widerstand des hydraulischen Systems,
$L_{hyd}$    die hydraulische Induktivität des hydraulischen Systems und
$H_{static}$    eine geodätische Förderhöhe ist.

Die numerische Lösung dieser ersten Gleichung GI1 kann durch eine zeitdiskrete Implementierung mit Hilfe der sogenannten Vorwärts-Euler-Integration erfolgen, wobei der Förderstrom $Q_{mdl}$ auf der linken Seite der Gleichung zum Zeitpunkt k+1 aus dem Förderstrom $Q_{mdl}$ auf der rechten Seite der Gleichung um Zeitpunkt k berechnet wird. Die numerisch lösbare zeitdiskrete Form der ersten Gleichung kann dann lauten:

$$\text{GI1:} \quad Q_{mdl}(k+1) = Q_{mdl}(k) + \frac{1}{L_{hyd}} \Big( (a\omega^2(k) - bQ_{mdl}(k)\omega(k) - cQ_{mdl}^2(k)) -$$
$$R_{hyd}Q_{mdl}^2(k) - H_{static}(k) \Big) \cdot \Delta t$$

Dabei ist $\Delta t$ das Zeitintervall zwischen dem Zeitpunkt k+1 und dem Zeitpunkt k.

Die Modellparameter a, b, c sind an sich bekannt, da sie den statischen mathematischen Zusammenhang H = f(Q, $\omega$) zwischen Förderhöhe H und Förderstrom Q für eine beliebige Drehzahl $\omega$, mit anderen Worten das sogenannte Pumpenkennfeld beschreiben, das bei Kreiselpumpenaggregaten regelmäßig werksseitig vermessen wird und aus der Summe aller Pumpenkurven, d.h. Kurven $H_\omega$ = f(Q) konstanter Drehzahl besteht, die vom Hersteller in der technischen Dokumentation des Pumpenaggregats angegeben werden. Demgegenüber sind der hydraulische Widerstand $R_{hyd}$ des Systems, die hydraulische Induktivität $L_{hyd}$ des Systems und dessen geodätische Förderhöhe $H_{static}$ abhängig vom System selbst, genauer gesagt von dessen Topologie und Zustand, wobei letzterer maßgeblich von der Stellung der Ventile im System abhängt, so dass dessen hydraulischer Widerstand veränderlich ist.

Vorzugsweise werden für den hydraulischen Widerstand $R_{hyd}$ und die hydraulische Induktivität $L_{hyd}$ zu Beginn des Verfahrens Schätzwerte verwendet. Durch die Anwendung des erfindungsgemäßen Verfahrens wird ein etwaiger Schätzfehler kompensiert.

Im Falle eines geschlossenen Rohrleitungsnetzwerks, wie dies beispielsweise bei einer Heizungsanlage oder Kühlanlage mit einem im Kreis zirkulierenden Wärmeträgermedium der Fall ist, ist die geodätische Förderhöhe gleich null, so dass für diesen Anwendungsfall $H_{static} = 0$ gesetzt werden kann. Der Wert für die geodätische Förderhöhe $H_{static}$ kann beispielsweise durch einen Nutzer an der Steuerungselektronik des Kreiselpumpenaggregats manuell vorgegeben werden, falls dieser konstant ist. Es ist aber auch möglich, dass die Steuerungselektronik den Wert für die geodätische Förderhöhe $H_{static}$ aufgrund einer Angabe zum Rohrleitungsnetzwerks oder der Anwendung (Heizungsanlage, Kühlanlage), in der das Kreiselpumpenaggregat betrieben wird, selbst einstellt, insbesondere auf null setzt. Im Falle einer veränderlichen geodätischen Höhe muss idese gemessen oder auf andere Weise bestimmt werden.

Um zusätzlich oder alternativ zum Förderstrom die Förderhöhe gezielt angeben zu können, kann die erste Gleichung (Volumenstromgleichung) in eine erste und zweite Teilgleichung aufgetrennt werden, wobei die erste Teilgleichung das statische hydraulische Pumpenkennfeld zur Berechnung der Förderhöhe beschreibt und die zweite Teilgleichung die dynamische Volumenstromgleichung unter Verwendung der berechneten Förderhöhe ist. Die zweite Teilgleichung kann auch als Hauptgleichung betrachtet werden, da sie die Integralform behält, wohingegen die erste Gleichung als Nebengleichung betrachtet werden kann, da sie einen in der Hauptgleichung benötigten Term liefert.

Die erste Teilgleichung, nachfolgend GI1a, und zweite Teilgleichung, nachfolgend GI1b können beispielsweise in der folgenden Form verwendet werden:

$$\text{GI1a:} \quad H_{mdl} = a\omega^2 - b\,Q_{mdl}\omega - cQ_{mdl}^2$$

$$\text{GI1b:} \quad Q_{mdl} = \frac{1}{L_{hyd}} \int_0^t \left( H_{mdl} - R_{hyd}Q_{mdl}^2 - H_{static} \right) dt$$

wobei $H_{mdl}$ die zu ermittelnde Förderhöhe der Kreiselpumpe ist, genauer gesagt eine Modellgröße.

Wie bereits zur ersten Gleichung GI1 erläutert, kann auch die numerische Lösung der zweiten Teilgleichung GI1b durch eine zeitdiskrete Implementierung mit Hilfe der Vorwärts-Euler-Integration erfolgen, wobei der Förderstrom $Q_{mdl}$ auf der linken Seite der Gleichung zum Zeitpunkt k+1 aus dem Förderstrom $Q_{mdl}$ auf der rechten Seite der Gleichung zum Zeitpunkt k berechnet wird. Die numerisch lösbare zeitdiskrete Form der zweiten Teilgleichung GI1b kann dann lauten:

$$\text{GI1b:} \quad Q_{mdl}(k+1) = Q_{mdl}(k) + \frac{1}{L_{hyd}} \left( H_{mdl}(k) - R_{hyd}Q_{mdl}^2(k) - H_{static}(k) \right) \cdot \Delta t$$

Dabei ist $\Delta t$ das Zeitintervall zwischen dem Zeitpunkt k+1 und dem Zeitpunkt k. Die erste Teilgleichung GI1b kann ebenfalls zeitdiskret implementiert werden:

$$\text{GI1a:} \quad H_{mdl}(k) = a\omega^2(k) - bQ_{mdl}(k)\omega(k) - cQ_{mdl}^2(k)$$

Prozesstechnisch kann die Auswertung der beiden Teilgleichungen GI1a, GI1b nacheinander erfolgen. Vorzugsweise wird dabei zunächst die erste Teilgleichung GI1a ausgewertet, d.h. die Förderhöhe $H_{mdl}$ berechnet, und zwar anhand eines initialen Förderstromwerts $Q_{mdl}(k=1) = Q_{start}$, der beispielsweise null sein kann. Anschließend wird anhand des ermittelten Förderhöhenwerts $H_{mdl}(k)$ die zweite Teilgleichung GI1b ausgewertet d.h. der neue Förderstromwert $Q_{mdl}(k+1)$ ermittelt.

Für die Auswertung der ersten Gleichung GI1 oder ihrer ersten Teilgleichung GI1a kann als Drehzahl $\omega$ in einer Ausführungsvariante die Istdrehzahl $\omega_{real}$ verwendet werden, die dem Pumpen-Motor-Modell hierfür eigens zugeführt werden kann. Diese Istdrehzahl $\omega_{real}$ kann gemessen oder von der Motorregelung des die Kreiselpumpe anreibenden Elektromotors berechnet werden, die das Drehmoment in Schritt a. einstellt.

Damit die Ergebnisse konsistent sind, kann alternativ für die Auswertung der ersten Gleichung GI1 oder ihrer ersten Teilgleichung GI1a als Drehzahl $\omega$ die Modelldrehzahl $\omega_{mdl}$ verwendet werden, die innerhalb des Pumpen-Motor-Modells zuvor mit Hilfe der zweiten Gleichung bzw. der Geschwindigkeitsgleichung GI2 berechnet wurde. Dies ist möglich, weil der das Störungssignal berechnende Störungsregler es schafft, einen etwaigen Drehzahlfehler sehr gut auszuregeln, so dass die Modelldrehzahl und die reale Drehzahl gleich sind.

Es sei angemerkt, dass für die modellbasierte Ermittlung des Förderstroms oder der Förderhöhe stets auch die jeweils andere Größe ermittelt werden muss, zumindest innerhalb des Pumpen-Motor-Modells, wobei jedoch je nach Wunsch, ob der Förderstrom oder die Förderhöhe oder beide Größen im Rahmen des erfindungsgemäßen Verfahrens ermittelt werden soll(en), entweder nur der Förderstrom oder nur die Förderhöhe oder beide Größen aus dem Pumpen-Motor-Modell ausgegeben werden.

Die Geschwindigkeitsgleichung kann beispielsweise in der folgenden Integralform verwendet werden:

$$\text{GI2: } \omega_{mdl} = \frac{1}{J}\int_0^t \left(T_{mot} - \left(a_t Q_{mdl}\omega - b_t Q_{mdl}^2 - c_t \frac{Q_{mdl}^3}{\omega} + v_i\omega^2 + v_s\omega - I\frac{\mathrm{d}Q}{\mathrm{d}t}\right) + T_D\right)dt$$

wobei

$T_{mot}$ das mechanische Drehmoment des Motors (Motormoment) der Kreiselpumpe,
$T_D$ das berechnete Störsignal in Form eines Moments (Störmoment),
$Q_{mdl}$ der zu ermittelnde Förderstrom der Kreiselpumpe,
$\omega_{mdl}$ die Modelldrehzahl bzw. Drehfrequenz der Kreiselpumpe ($\omega = 2\pi n$),
$\omega$ eine Drehzahl bzw. Drehfrequenz der Kreiselpumpe ($\omega = 2\pi n$),
$a_t, b_t, c_t$ Parameter sind, die das statische Drehmomentkennfeld
($T(Q, \omega)$) der Kreiselpumpe anhand von Drehmomentkurven beschreiben,
$v_i$ eine die Reibung zwischen Laufrad und Medium beschreibende Größe,
$v_s$ eine die Lagerreibung beschreibende Größe,
$J$ die Massenträgheit der rotierenden Komponenten der Kreiselpumpe (Laufrad, Welle, Rotor), und
$I$ die Massenträgheit des Fördermediums im Laufrad ist.

Die Geschwindigkeitsgleichung GI2 beschreibt in Integralform eine hydromechanische Differentialgleichung in der Art einer Drehmomentbilanz, in der die Abweichung zwischen dem Motormoment $T_{mot}$ und dem theoretischen Pumpendrehmoment $T_{mdl}$ zuzüglich eines modellierungsfehlerbedingten Störmoments $T_D$ integriert wird. Das Motormoment $T_{mot}$ wird von der Motorregelung des die Kreiselpumpe anreibenden Elektromotors eingestellt, um die Solldrehzahl zu erreichen, oder wird direkt moduliert, und ist insoweit aus der Motorregelung bekannt. Für die Auswertung der zweiten Gleichung GI2 kann wie bei der ersten Gleichung GI1 als Drehzahl $\omega$ die Istdrehzahl $\omega_{real}$ oder die Modelldrehzahl $\omega_{mdl}$ verwendet werden.

Die zweite Gleichung GI2 kann ebenfalls numerisch gelöst werden durch eine zeitdiskrete Implementierung mit Hilfe der Vorwärts-Euler-Integration, wobei die Drehzahl $\omega_{mdl}$ auf der linken Seite der Gleichung zum Zeitpunkt k+1 aus der Drehzahl $\omega_{mdl}$ auf der rechten Seite der Gleichung zum Zeitpunkt k berechnet wird. Die numerisch lösbare zeitdiskrete Form der zweiten Gleichung GI2 kann dann lauten:

$$\text{GI2: } \omega_{mdl}(k+1) = \omega_{mdl}(k) + \frac{1}{J}\Big(T_{mot}(k) - \Big(a_t Q_{mdl}(k)\omega(k) - b_t Q_{mdl}^2(k) -$$

$$c_t \frac{Q_{mdl}^3(k)}{\omega(k)} + v_i\omega^2(k) + v_s\omega(k) - I\frac{Q(k)-Q(k-1)}{\Delta t}\Big) + T_D(k)\Big)\cdot\Delta t$$

Dabei ist $\Delta t$ wieder das Zeitintervall zwischen dem Zeitpunkt k+1 und dem Zeitpunkt k.

Das theoretische Pumpendrehmoment $T_{mdl}$ ergibt sich aus einer Modellgleichung, die in der zweiten Gleichung GI2 durch den inneren Klammerausdruck beschrieben ist. Darin sind die Modellparameter $a_t, b_t, c_t$ an sich bekannt, da sie den statischen mathematischen Zusammenhang $T = f(Q, \omega)$ zwischen dem Drehmoment T und dem Förderstrom Q für eine beliebige Drehzahl $\omega$, mit anderen Worten das Drehmomentkennfeld beschreiben, das bei Kreiselpumpenaggregaten werksseitig vermessen werden kann und aus der Summe aller Drehmomentkurven, d.h. Kurven $T_\omega = f(Q)$ konstanter Drehzahl besteht. Die Modellparameter $a_t, b_t, c_t$ unterliegen einerseits einer Serienstreuung, d.h. sie unterscheiden sich von Kreiselpumpenaggregat zu Kreiselpumpenaggregat aufgrund von Toleranzen geringfügig, insbesondere um wenige Prozent. Andererseits unterliegen sie einer alterungsbedingten Änderung, insbesondere aufgrund von Lagerverschleiß und Ablagerungen am Laufrad. Die die Reibung zwischen Laufrad und Medium beschreibende Größe $v_i$ und die die Lagerreibung (viskose Reibung im hydrodynamischen Gleitlager) beschreibende Größe $v_s$ können durch werksseitige Vermessung des Kreiselpumpenaggregats ebenfalls jeweils ermittelt werden und sind insoweit bekannte Größen. Die Massenträgheit $J$ kann aus Designdaten des Kreiselpumpenaggregats berechnet oder gemessen werden und liegt herstellerseitig somit ebenfalls vor. Selbiges gilt für die Massenträgheit $I$ des Fördermediums im Laufrad, welche jedoch vernachlässigbar gering ist, so dass der Term $I\frac{\mathrm{d}Q}{\mathrm{d}t}$ zu null gesetzt werden kann.

Um die Berechnung der Geschwindigkeitsgleichung GI2 zu vereinfachen, kann diese in eine erste und zweite Teilgleichung GI2a, GI2b aufgetrennt werden, wobei die erste Teilgleichung GI2a das statische hydromechanische Pumpenkennfeld (Drehmomentkennfeld) zur Berechnung des theoretischen Pumpendrehmoments beschreibt und die zweite Teilgleichung GI2b die dynamische Geschwindigkeitsgleichung unter Verwendung des berechneten theoretischen Pumpendrehmoments ist. Die zweite Teilgleichung kann auch in diesem Fall als Hauptgleichung betrachtet werden, da sie die Integralform behält, wohingegen die erste Gleichung als Nebengleichung betrachtet werden kann, da sie einen in der Hauptgleichung benötigten Term liefert.

Die erste Teilgleichung GI2a und zweite Teilgleichung GI2b können beispielsweise in der folgenden Form verwendet werden:

$$\text{GI2a:} \qquad T_{mdl} = a_t Q_{mdl} \omega - b_t Q_{mdl}^2 - c_t \frac{Q_{mdl}^3}{\omega} + v_i \omega^2 + v_s \omega - I \frac{dQ}{dt}$$

$$\text{GI2b:} \qquad \omega_{mdl} = \frac{1}{J} \int_0^t (T_{mot} - T_{mdl} + T_D)\, dt$$

wobei $T_{mdL}$ das zu berechnende theoretischen Pumpendrehmoment der Kreiselpumpe ist, genauer gesagt eine Modellgröße.

Die numerische Lösung der zweiten Teilgleichung GI2b kann wieder durch eine zeitdiskrete Implementierung mit Hilfe der Vorwärts-Euler-Integration erfolgen, wobei die Drehzahl $\omega_{mdl}$ auf der linken Seite der Gleichung zum Zeitpunkt k+1 aus der Drehzahl $\omega_{mdl}$ auf der rechten Seite der Gleichung zum Zeitpunkt k berechnet wird. Die numerisch lösbare zeitdiskrete Form der zweiten Teilgleichung GI2b kann dann lauten:

$$\text{GI2b:} \quad \omega_{mdl}(k+1) = \omega_{mdl}(k) + \frac{1}{J}\left(T_{mot}(k) - T_{mdl}(k) + T_D(k)\right) \cdot \Delta t$$

Die erste Teilgleichung GI2a kann ebenfalls zeitdiskret implementiert werden:

$$\text{GI2a:} \quad T_{mdl}(k) = a_t Q_{mdl}(k)\omega(k) - b_t Q_{mdl}^2(k) - c_t \frac{Q_{mdl}^3(k)}{\omega(k)} + v_i \omega^2(k) + v_s \omega(k) -$$

$$I \frac{Q(k) - Q(k-1)}{\Delta t}$$

wobei der Term $I \frac{Q(k) - Q(k-1)}{\Delta t}$ auch vernachlässigt werden kann. Prozesstechnisch kann die Auswertung der beiden Teilgleichungen der Geschwindigkeitsgleichung nacheinander erfolgen. Vorzugsweise wird dabei zunächst die erste Teilgleichung GI2a ausgewertet, d.h. das Pumpendrehmoment berechnet, und zwar einerseits anhand eines initialen Förderstromwerts $Q_{mdl}(k=1) = Q_{start}$, der beispielsweise null sein kann, und andererseits anhand eines initialen Drehzahlwerts $\omega_{mdl}(k=1) = \omega_{start}$ größer null, . Anschließend wird anhand des ermittelten Pumpendrehmoments $T_{mdl}(k)$ die zweite Teilgleichung GI2b ausgewertet d.h. die neue Modelldrehzahl $\omega_{mdl}(k+1)$ ermittelt.

Um das Störungssignal zu berechnen, kann die Differenz zwischen der Istdrehzahl und der Modelldrehzahl einem wenigstens einen Integralanteil enthaltenden Regler zugeführt werden. Beispielsweise kann der Regler ein I-, PI oder PID-Regler sein, wie er in der Regelungstechnik allgemein bekannt ist. Das Störungssignal kann das Ausgangssignal des Reglers sein oder aus diesem Reglerausgangssignal berechnet sein. Der Regler kann mit dem Wert null initialisiert werden. Besteht keine Abweichung zwischen der Modelldrehzahl und Istdrehzahl, bleibt das Störungssignal unverändert. Ist die Differenz größer null, steigt der Wert des Störungssignals, ist es kleiner null fällt der Wert des Störungssignals. Der Regler kann insoweit als "Störungsregler" bezeichnet werden, der die Abweichung zwischen der realen Pumpe und dem Pumpenmodell kompensiert und die Modelldrehzahl der Istdrehzahl angleicht. Der Reglerausgang ist damit ein Maß für die (Drehmoment-)Abweichung bzw. Störung des Modells. Durch die erfindungsgemäße Auswertung dieser Störung kann das Modell dynamisch angeglichen werden.

Wie bereits erwähnt, kann in einer Ausführungsvariante das Ausgangssignal dieses Reglers das Störungssignal $T_D$ bilden. Da dieses Signal $T_D$ in eine Drehmomentgleichung eingeht, ist die physikalische Größe des Reglerausgangs ein Moment bzw. "Störmoment", denn eine Reglerausgangsgröße hat stets die Dimension der Stellgröße, auf die der Regler einwirkt. In einer anderen Ausführungsvariante kann das Störungssignal durch Multiplikation des Ausgangssignals des genannten Reglers mit der Istdrehzahl gebildet werden, so dass dieses Störsignal eine Leistung repräsentiert. Das Störungssignal $P_D$ kann somit in diesem Fall als eine "Störleistung" betrachtet werden. Ein Grundgedanke des erfindungsgemäßen Verfahrens besteht somit darin, den zumindest einen Modellparameter, oder sogar mehrere Modellparameter gleichzeitig, so anzupassen, dass kein Störmoment $T_D$ und/ oder keine Störleistung $P_D$ vorliegt. Mit anderen Worten wird das Pumpen-Motor-Modell kontinuierlich angepasst, so dass es stets die Realität nachbildet und externe Störeinflüsse auf das Kreiselpumpenaggregat sowie etwaige Modellfehler kompensiert. Das Pumpen-Motor-Modell ist insoweit also dynamisch.

Gemäß einer Weiterbildung des Verfahrens ist auch die Kombination der genannten beiden Ausführungsvarianten möglich. So kann in Schritt d. ein erstes Störungssignal $T_D$ und ein zweites Störungssignal $P_D$ ermittelt werden, indem die Differenz zwischen der Modelldrehzahl und der Istdrehzahl einem wenigstens einen Integralanteil enthaltenden Reglers zugeführt wird, das Ausgangssignal dieses Reglers das erste Störungssignal $T_D$ bildet und das zweite Störungssignal $P_D$ dann durch Multiplikation des Ausgangssignals dieses Reglers mit der Istdrehzahl gebildet wird. Mit anderen Worten kann das zweite Störungssignal als aus dem ersten Störungssignal berechnet betrachtet werden. Es liegen dann zwei Störungssignale $T_D$, $P_D$ vor, die getrennt voneinander weiterverarbeitet werden können und jeweils die Möglichkeit bieten, eine oder mehr Modellvariablen des Pumpen-Motor-Modells anzupassen bzw. nachzuführen.

Vorzugsweise ist vorgesehen, dass aus dem Störungssignal $T_D$ ein Korrektursignal $T_{D1sin}$ bestimmt und zur Anpassung eines Modellparameters des Pumpen-Motor-Modells verwendet wird. Es ist ferner möglich, dass aus dem Störungssignal $T_D$ zwei oder mehr Korrektursignale $T_{D1sin}$, $T_{D1cos}$ bestimmt und diese jeweils zur Anpassung eines Modellparameters des Pumpen-Motor-Modells verwendet werden. Auf diese Weise können folglich zwei oder eine der Anzahl an Korrektursignalen entsprechende Anzahl unterschiedlicher Modellparameter gleichzeitig angepasst werden. Schließlich ist es auch möglich, dass aus jedem der Störungssignale $T_D$, $P_D$ ein, zwei oder sogar mehr Korrektursignale $T_{D1sin}$, $T_{D1cos}$, $P_{D1sin}$, $P_{D1cos}$ bestimmt werden, und dass jedes Korrektursignal $T_{D1sin}$, $T_{D1cos}$, $P_{D1sin}$, $P_{D1cos}$ zur Anpassung jeweils eines bestimmten Modellparameters $R_{hyd}$, J, $L_{hyd}$, ct des Pumpen-Motor-Modells verwendet wird. Dies ermöglicht es, drei, vier oder mehr Modellvariablen des Pumpen-Motor-Modells gleichzeitig und unabhängig voneinander anzupassen. Prinzipiell kann jedes der Korrektursignale dazu verwendet werden, einen der Modellparameter anzupassen. Jedoch ist zu beachten, dass jene Korrektursignale, die einen Wirkanteil repräsentieren, d.h. mit der Anregung der Drehzahl oder des Drehmoments in Phase liegen, solche Modellparameter korrigieren, die vorwiegend auf die Wirkleistung wirken. Korrektursignale, die eine Blindleistung repräsentieren, d.h. 90° phasenverschoben zur Anregung sind, können dagegen nur Modellparameter korrigieren, die vorwiegend die Blindleistung beeinflussen.

Beispielsweise kann der anzupassende Modellparameter der hydraulische Widerstand $R_{hyd}$ des Rohrleitungsnetzwerks oder der Modellparameter ct sein. Der hydraulische Widerstand $R_{hyd}$ gibt die Steilheit der Kennlinie des Rohrleitungssystems an. Er ändert sich, wenn das Rohrleitungssystem geregelte Ventile aufweist, wie dies beispielsweise in Heizungs- oder Kühlungsanlagen der Fall ist. Den hydraulischen Widerstand $R_{hyd}$ im Pumpen-Motor-Modell nachzuführen, ist deshalb von besonderem Vorteil, um die Genauigkeit der Förderhöhen- und/ oder Förderstromermittlung zu gewährleisten. Der Modellparameter ct unterliegt von Kreiselpumpenaggregat zu Kreiselpumpenaggregat der Serienstreuung und ändert sich auch mit dem Alter des Kreiselpumpenaggregats, wohingegen die übrigen Parameter at und bt keine starke Abhängigkeit haben und nahezu konstant bleiben. Die Modellparameter $R_{hyd}$, ct beeinflussen die Wirkleistung. Deshalb ist in diesem Fall vorgesehen, dass in Schritt e. dasjenige Sinus- oder Cosinussignal verwendet wird, das mit dem Anregungssignal in Phase liegt. Mit anderen Worten wird in Schritt e. das Sinussignal verwendet, wenn auch das Anregungssignal ein Sinussignal ist, und das Cosinussignal verwendet, wenn auch das Anregungssignal ein Cosinussignal ist.

Um in einer bevorzugten Ausführungsvariante beide genannten Modellvariablen $R_{hyd}$, ct anzupassen, kann der hydraulische Widerstand $R_{hyd}$ in Abhängigkeit eines ersten Korrektursignals $P_{D1sin}$ angepasst werden, das aus dem zweiten Störungssignal $P_D$ gebildet wird, und der Modellparameter ct in Abhängigkeit eines ersten Korrektursignals $T_{D1sin}$ angepasst werden, das aus dem ersten Störungssignal $T_D$ gebildet wird. Es ist jedoch auch umgekehrt möglich, d.h. dass der hydraulische Widerstand $R_{hyd}$ in Abhängigkeit des aus dem ersten Störsignal $T_D$ gebildeten ersten Korrektursignals $T_{D1sin}$ und der Modellparameter ct in Abhängigkeit des aus dem zweiten Störungssignals $P_D$ gebildeten ersten Korrektursignals $P_{D1sin}$ angepasst wird. Die erstgenannte Variante hat jedoch den Vorteil, dass der ct-Term

$$c_t \frac{Q^3}{\omega}$$

der Drehmomentgleichung (GI2) in der korrespondierenden Leistungsgleichung aufgrund der Multiplikation mit der Drehzahl ($P = T \cdot \omega$) nur als $c_t Q^3$ wirkt und in der Integration dieser Leistungsgleichung herausfällt. Ferner ist es selbstverständlich auch möglich, dass in einer Ausführungsvariante nur einer der genannten Modellparameter $R_{hyd}$, ct angepasst wird und hierzu dann entweder das erste Korrektursignal $T_{D1sin}$ des ersten Störungssignals $T_D$, oder das erste Korrektursignal $P_{D1sin}$ des zweiten Störungssignals $P_D$ verwendet wird.

Gemäß einer Ausführungsvariante kann der anzupassende Modellparameter die Massenträgheit J des Kreiselpumpenaggregats oder die hydraulische Induktivität $L_{hyd}$ des Rohrleitungsnetzwerks sein. Eine Anpassung bzw. Nachführung der Trägheit J des Kreiselpumpenaggregats als Modellparameter hat den Vorteil, dass Alterungserscheinungen am Kreiselpumpenaggregat wie z.B. Ablagerungen am Laufrad (Verockerung) oder Lagerverschleiß erkannt werden können, da diese die Trägheit erhöhen. Wird im Rahmen des Verfahrens somit der Modellparameter "Trägheit" erhöht, kann bei Überschreiten eines vorbestimmten Grenzwertes ein Hinweis, insbesondere eine Wartungsinformation am Kreiselpumpenaggregat ausgegeben werden. Eine Anpassung bzw. Nachführung der hydraulischen Induktivität als Modellparameter hat den Vorteil, dass strukturelle Änderungen am Rohrleitungssystem erkannt werden können, beispielsweise infolge eines Fehlers, durch den ein Netzabschnitt dauerhaft vom Rest abgeschnitten wird, oder infolge eines Umbaus oder einer Erweiterung des Rohrleistungsnetzes. Die Erkenntnis über eine sich erhöhende oder verringernde hydraulische Induktivität kann ebenfalls dazu verwendet werden, einen Hinweis am Kreiselpumpenaggregat z.B. zwecks Überprüfung der Betriebseinstellung des Kreiselpumpenaggregats auszugeben und/ oder direkt die Regelung des Kreiselpumpengaggregats anzupassen, beispielsweise durch Erhöhung oder Verringerung seiner Bezugsdrehzahl oder einer eingestellten Regelungskennlinie. Diese Modellparameter J, $L_{hyd}$, beeinflussen die Blindleistung. Deshalb ist in diesem Fall vorgesehen, dass in Schritt e. dasjenige Sinus- oder Cosinussignal verwendet wird, das zum Anregungssignal 90° phasenverschoben ist. Mit anderen Worten wird in Schritt e. das Cosinussignal verwendet, wenn das Anregungssignal ein Sinussignal ist, und das Sinussignal verwendet, wenn das Anregungssignal ein Cosinussignal ist.

Um in einer bevorzugten Ausführungsvariante beide genannten Modellvariablen J, $L_{hyd}$ anzupassen, kann die Trägheit J in Abhängigkeit eines zweiten Korrektursignals $P_{D1cos}$ angepasst werden, das aus dem zweiten Störungssignal $P_D$ gebildet wird, und die hydraulische Impedanz $L_{hyd}$ in Abhängigkeit eines zweiten Korrektursignals $T_{D1cos}$ angepasst werden, das aus dem ersten Störungssignal $T_D$ gebildet wird. Es ist jedoch auch umgekehrt möglich, d.h. dass die Trägheit J in Abhängigkeit des aus dem ersten Störsignal $T_D$ gebildeten zweiten Korrektursignals $T_{D1cos}$ und die hydraulische Impedanz $L_{hyd}$ in Abhängigkeit des aus dem zweiten Störungssignals $P_D$ gebildeten zweiten Korrektursignals $P_{D1cos}$ angepasst wird. Ferner ist es selbstverständlich auch möglich, dass in einer Ausführungsvariante nur einer der genannten Modellparameter J, $L_{hyd}$ angepasst wird und hierzu dann entweder das zweite Korrektursignal $T_{D1cos}$ des ersten Störungssignals $T_D$, oder das zweite Korrektursignal $P_{D1cos}$ des zweiten Störungssignals $P_D$ verwendet wird.

In einer Ausführungsvariante kann ferner vorgesehen sein, dass alle vier vorgenannten Modellparameter Rhyd, ct, J, $L_{hyd}$ jeweils in Abhängigkeit der zuvor genannten Korrektursignale $T_{D1sin}$, $T_{D1cos}$, $P_{D1sin}$, $P_{D1cos}$ gleichzeitig angepasst werden, d.h. beispielsweise

- der hydraulische Widerstand $R_{hyd}$ in Abhängigkeit des aus dem zweiten Störungssignal $P_D$ gebildeten ersten Korrektursignals $P_{D1sin}$,
- der Modellparameter ct in Abhängigkeit des aus dem ersten Störungssignal $T_D$ gebildeten ersten Korrektursignals $T_{D1sin}$
- die Trägheit J in Abhängigkeit des aus dem zweiten Störungssignal $P_D$ gebildeten zweiten Korrektursignals $P_{D1cos}$ und
- die hydraulische Impedanz $L_{hyd}$ in Abhängigkeit des aus dem ersten Störungssignal $T_D$ gebildeten zweiten Korrektursignals $T_{D1cos}$.

Bei Schritt e. handelt es sich mathematisch quasi um eine Sinus-! Cosinus-Transformation, die, auf einem Prozessor ausgeführt, diskret durchgeführt wird. Nachfolgend wird gleichwohl der Einfachheit halber die zeitkontinuierliche Darstellung der mathematischen Zusammenhänge verwendet.

Bevorzugt erfolgt die Bestimmung des Korrektursignals, bzw. im Falle mehrerer Korrektursignale des jeweiligen Korrektursignals, durch die Verwendung eines Sinus- oder Cosinussignals mit dem Einfachen der Anregungsfrequenz. Hat das Anregungssignal also beispielsweise die Frequenz ωt, so besitzt in diesem Fall auch das Sinus- oder Cosinussignal, das mit dem Störungssignal, bzw. im Falle zweier Störungssignale mit dem jeweiligen Störungssignal, multipliziert wird, diese einfache Frequenz ωt, nachfolgend auch als Grundfrequenz bezeichnet. Es besteht aber auch alternativ oder zum Erhalt weiterer Korrektursignale zusätzlich die Möglichkeit, ein Sinus- oder Cosinussignal mit der doppelten, dreifachen oder einem anderen n-ten Vielfachen der Grundfrequenz zu verwenden, also mit einer Frequenz 2ωt, 3ωt oder nωt. Da aber die Amplitude des Korrektursignals bei Verwendung der Grundfrequenz am größten ist, ist die Verwendung eines Sinus- oder Cosinussignals mit dem Einfachen der Anregungsfrequenz, d.h. der Grundfrequenz die bevorzugte Wahl. Wie oben beschrieben können in diesem Fall bereits zwei Modellparameter pro Störungssignal (ein Modellparameter bei Verwendung eines Sinussignals mit Grundfrequenz und einer bei Verwendung eines Cosinussignals mit Grundfrequenz in Schritt e.) angepasst werden, mithin bei zwei Störungssignalen (Störmoment und Störleistung) also vier Modellparameter. Wird zusätzlich das Doppelte der Grundfrequenz verwendet, können zwei, bei zwei Störungssignalen sogar vier weitere Modellparameter angepasst werden.

Die Korrektursignale können in diesem Fall mathematisch wie folgt gebildet sein: unter Verwendung der Grundfrequenz des Anregungssignals:

- das erste Korrektursignal $T_{D1sin}$ des ersten Störungssignals $T_D$:

$$T_{D1sin} = \frac{1}{T} \int_0^T T_D \cdot \sin(\omega_A t)\,dt$$

- das zweite Korrektursignal $T_{D1cos}$ des ersten Störungssignals $T_D$:

$$T_{D1cos} = \frac{1}{T} \int_0^T T_D \cdot \cos(\omega_A t)\,dt$$

- das erste Korrektursignal $P_{D1sin}$ des zweiten Störungssignals $P_D$:

$$P_{D1sin} = \frac{1}{T} \int_0^T P_D \cdot \sin(\omega_A t)\,dt$$

- das zweite Korrektursignal $P_{D1cos}$ des zweiten Störungssignals $P_D$:

$$P_{D1cos} = \frac{1}{T} \int_0^T P_D \cdot \cos(\omega_A t)\,dt$$

und unter Verwendung des n-ten Vielfachen der Grundfrequenz des Anregungssignals:

- ein Korrektursignal $T_{Dnsin}$ des ersten Störungssignals $T_D$:

$$T_{Dnsin} = \frac{1}{T} \int_0^T T_D \cdot \sin(n\omega_A t)\,dt$$

- ein Korrektursignal $P_{Dncos}$ des zweiten Störungssignals $P_D$:

$$P_{Dncos} = \frac{1}{T} \int_0^T P_D \cdot \cos(n\omega_A t)\,dt$$

Mathematisch betrachtet, handelt es sich bei der Berechnung des wenigstes einen oder der mehreren Korrektursignale um eine Art Fourier Analyse, bei der jedoch nur für einzelne, wenige Frequenzen Integrale berechnet werden. Diese Integrale können als Fourier Integrale betrachtet werden.

Es ist des Weiteren möglich, den Gleichanteil des Störungssignals zu verwenden, um auch mit diesem einen bestimmten Modellparameter anzupassen bzw. nachzuführen.

Vorzugsweise erfolgt die Anpassung des bzw. des entsprechenden Modellparameters $R_{hyd}$, J, $L_{hyd}$, $c_t$ unter Verwendung eines zumindest einen Integralanteil enthaltenden Reglers, dem das bzw. das jeweilige Korrektursignal $T_{D1sin}$, $T_{D1cos}$, $P_{D1sin}$, $P_{D1cos}$ zugeführt wird, wobei das Reglerausgangssignal mit einem Initialwert für den bzw. den entsprechenden Modellparameter ($R_{hyd}$, J, $L_{hyd}$, ct) multipliziert wird, um den angepassten Modellparameter $R_{hyd}$, J, $L_{hyd}$, ct zu erhalten. Der Initialwert kann ein werksseitig vermessener Wert (bei der Trägheit J oder ct) oder ein für den bestimmungsgemäßen Betrieb des Kreiselpumpenaggregats angenommener Mittelwert sein (bei $R_{hyd}$, $L_{hyd}$). Der Regler kann ein I-, PI- oder PID-Regler sein. Durch den Integralanteil (I-Anteil) im Regler wirkt dieser wie ein Integrator.

Das Reglerausgangssignal kann als Korrekturfaktor K für den Modellparameter verstanden werden. Der Regler kann zu Beginn des Verfahrens mit dem Wert 1 initialisiert werden, so dass das Reglerausgangssignal K = 1 ist und die Multiplikation mit dem Initialwert ergibt, dass der angepasste Modellparameter bei Verfahrensbeginn gleich dem Initialwert ist, also unverändert bleibt. Ist das Korrektursignal gleich null, verbleibt das Reglerausgangssignal bei K = 1. Ist das Korrektursignal jedoch größer 0, erhöht sich der Korrekturfaktor K, ist das Korrektursignal kleiner als 0, verringert sich der Korrekturfaktor K. Infolge der Multiplikation des Korrekturfaktors K mit dem Initialwert wird dadurch dann der Modellparameter erhöht oder verringert. Der Regler kann somit als "Parameterregler" bezeichnet werden. Der Vorteil an dieser Anordnung ist, dass der Regler einfach begrenzt werden kann. So kann der Korrekturfaktor z.B. auf einen Faktor 5 begrenzt werden, wobei zulässige Werte bevorzugt zwischen 1/5 und 5 liegen können. Dadurch lässt sich feststellen, wie weit sich der Wert von der initialen Annahme, d.h. dem Initialwert wegbewegt hat.

Weitere Merkmale, Eigenschaften, Wirkungen und Vorteile der Erfindung werden nachfolgend anhand von Ausführungsbeispielen und der beigefügten Figuren näher erläutert. Die in den Figuren enthaltenen Bezugzeichen behalten von Figur zu Figur ihre Bedeutung. In den Figuren bezeichnen Bezugzeichen stets dieselben oder zumindest äquivalente Komponenten, Bereiche, Richtungs- oder Ortsangaben.

Es sei darauf hingewiesen, dass im Rahmen der vorliegenden Beschreibung die Begriffe "aufweisen", "umfassen" oder "beinhalten" keinesfalls das Vorhandensein weiterer Merkmale ausschließen. Ferner schließt die Verwendung des unbestimmten Artikels bei einem Gegenstand nicht dessen Plural aus.

Es zeigen:

| | |
|---|---|
| Figur 1: | eine schematische Darstellung eines Kreiselpumpenaggregats innerhalb eines geschlossenen hydraulischen Systems |
| Figur 2: | ein Signalflussdiagramm einer ersten Ausführungsvariante des erfindungsgemäßen Verfahrens mit singulärer Modellparameteranpassung |
| Figur 3: | ein Signalflussdiagramm mit einer Ausführungsvariante des Pumpen-Motor-Modells 9 in Figur 2 |
| Figur 4: | eine Ausführungsvariante des Störungsreglers 10 in Figur 2 |
| Figuren 5-8: | verschiedene Ausführungsvarianten des Parameterreglers 12 in Figur 2 |
| Figur 9: | ein Signalflussdiagramm einer zweiten Ausführungsvariante des erfindungsgemäßen Verfahrens mit singulärer Modellparameteranpassung und fehlender Istdrehzahlzuführung zum Pumpen-Motor-Modell 9 |
| Figur 10: | ein Signalflussdiagramm mit einer Ausführungsvariante des Pumpen-Motor-Modells 9a in Figur 9 mit interner Verwendung der Modelldrehzahl |
| Figur 11: | ein Signalflussdiagramm einer dritten Ausführungsvariante des erfindungsgemäßen Verfahrens umfassend eine Multimodellparameteranpassung und einer einzigen Störgröße ausgangsseitig des Störungsreglers 10 |
| Figur 12: | ein Signalflussdiagramm einer vierten Ausführungsvariante des erfindungsgemäßen Verfahrens mit Multimodellparameteranpassung und zwei Störgrößen ausgangsseitig des Störungsreglers 10a |
| Figur 13: | eine Ausführungsvariante des Störungsreglers 10a in Figur 12 |
| Figur 14: | ein Signalflussdiagramm mit einer Ausführungsvariante des Pumpen-Motor-Modells 9b in Figuren 11 und 12 mit Multimodellparameteranpassung |

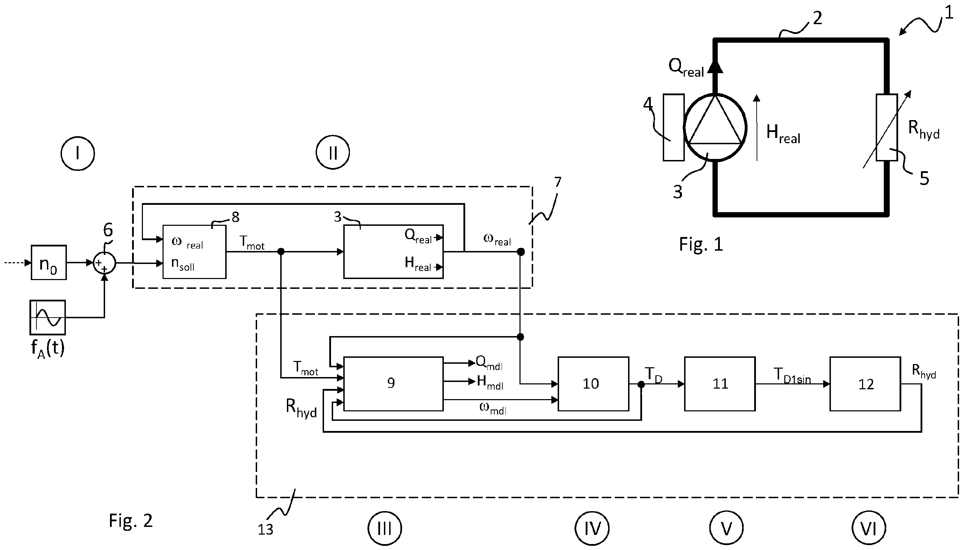

Figur 1 zeigt eine rein schematische Darstellung eines Kreiselpumpenaggregats 3, 4 innerhalb eines geschlossenen hydraulischen Systems 1, in dem das Kreiselpumpenaggregat 3, 4 eine Flüssigkeit umwälzt. Das hydraulische System 1 kann beispielsweise eine Heizungsanlage oder eine Kühlanlage für Gebäude sein, wobei aus Gründen der Einfachheit Systemkomponenten wie Heizquelle oder Chiller, Wärmetauscher, hydraulische Weiche, Ventile usw. weggelassen sind. Das hydraulische System 1 umfasst allerdings ein Rohrleitungsnetzwerk 2, das sich von dem Kreiselpumpenaggregat 3, 4 zu einer Anzahl von Verbrauchern erstreckt (Vorlauf), wie beispielsweise Heizkörper, Heizkreise einer Fußbodenheizung oder Kühlkreise einer Kühldecke, und von diesen Verbrauchern wieder zurück zum Kreiselpumpenaggregat 3, 4 erstreckt (Rücklauf). Das Kreiselpumpenaggregat 3, 4 ist in diesem Fall dazu bestimmt, ein Wärmeträgermedium, wie beispielsweise Wasser, zu den Verbrauchern zu fördern. Diesen Verbrauchern sind Stellventile wie z.B. Thermostatventile oder elektrothermische Stellantriebe zugeordnet, um den Volumenstrom durch den jeweiligen Verbraucher oder durch eine Gruppe von Verbrauchern einzustellen. Aufgrund des sich ändernden Öffnungsgrades dieser Stellventile ändert sich je nach Bedarf seitens der Verbraucher die vom Kreiselpumpenaggregat 3, 4 zu bedienende hydraulische Last 5, die in Figur 1 der Einfachheit halber durch einen einzigen, allerdings veränderlichen hydraulischen Widerstand $R_{hyd}$ symbolisiert ist. Er beschreibt die Steilheit der sogenannten Rohrnetzparabel des hydraulischen Systems 1, allgemein auch Anlagenkennlinie oder Anlagenkurve genannt.

Es sei angemerkt, dass das hydraulische System ebenso ein offenes System sein kann, wie z.B. im Falle einer Bohrlochpumpe, einer Abwasserhebeanlage oder einer Trinkwasserdruckerhöhungsanlage.

Das Kreiselpumpenaggregat 3, 4 umfasst eine Kreiselpumpe 4 samt elektromotorischer Antriebseinheit und eine Pumpen- bzw. Steuerungselektronik 4 zur Steuerung und/ oder Regelung des Elektromotors, die außerdem zur Ausführung des erfindungsgemäßen Verfahrens eingerichtet ist. Der Elektromotor kann beispielsweise ein dreiphasiger, permanenterregter, elektronisch kommutierter Synchronmotor sein. Die Steuerungselektronik 4 weist zur Einstellung einer bestimmten Drehzahl des Elektromotors einen Frequenzumrichter auf. Im Betrieb erzeugt die Kreiselpumpe 4 einen Differenzdruck zwischen ihrer Saug- und Druckseite, auch Förderhöhe $H_{real}$ genannt, der je nach hydraulischem Widerstand $R_{hyd}$ des mit der Kreiselpumpe 4 verbundenen Rohrleitungsnetzes 2 zu einem Förderstrom $Q_{real}$ führt.

Ein Signalflussdiagramm, das den Ablauf einer ersten Ausführungsvariante des erfindungsgemäßen Verfahrens zur möglichst genauen rechnerischen Bestimmung der aktuellen Förderhöhe $H_{real}$ und/ oder des aktuellen Förderstroms Qreai veranschaulicht, ist in Figur 2 dargestellt. Das Verfahren kann grob in sechs Verfahrensabschnitte I bis VI eingeteilt werden, die nachfolgend einzeln erläutert werden. Die Verfahrensabschnitte I bis IV finden im Grunde genommen gleichzeitig statt und werden infolge ihrer programmtechnischen Abarbeitung durch eine Software in der Steuerungselektronik 4 wiederholt zyklisch nacheinander ausgeführt, insbesondere mit der Taktgeschwindigkeit eines nicht dargestellten Prozessors in der Steuerungselektronik 4, auf dem das erfindungsgemäße Verfahren abläuft.

Im ersten Verfahrensabschnitt I erfolgt eine periodische Anregung des hydraulischen Systems 1. Dies erfolgt in dieser Ausführungsvariante, indem eine Bezugsdrehzahl $n_0$ des Kreiselpumpenaggregat 3, 4 mit einem periodischen Anregungssignal $f_A(t)$ einer bestimmten Anregungsfrequenz $\omega_A$ beaufschlagt wird, um eine modulierte Solldrehzahl $n_{soll}$ zu erhalten und damit die Istdrehzahl $n_{real}$ der Kreiselpumpe 3 zu modulieren, insbesondere periodisch schwanken zu lassen. Es sei an dieser Stelle angemerkt, dass in den Figuren an verschiedenen Stellen die Drehfrequenz $\omega$ anstelle der Drehzahl n verwendet ist, die aufgrund des Zusammenhangs $\omega = 2\pi n$ allerdings der Drehzahl entspricht und synonym zu dieser verstanden wird, weshalb nachfolgend allgemein von der "Drehzahl $\omega$" die Rede ist.

Die periodische Anregung $f_A(t)$ hat zur Folge, dass der Differenzdruck $\Delta p$ der Kreiselpumpe 3 bzw. ihre dazu proportionale Förderhöhe $H_{real}$ moduliert wird, was je nach Modulationsamplitude und -frequenz zu einer signaltechnischen Antwort des hydraulischen Systems 1 führt, die sich wiederum in dem zur Einstellung der modulierten Solldrehzahl $n_{soll}$ notwendigen Drehmoment, und auch in der elektrischen Leistungsaufnahme des Kreiselpumpenaggregats niederschlägt, woraus der Förderstrom Q ermittelt werden kann. Dieses Grundprinzip ist in der deutschen Patentanmeldung DE 102014004336 A1 beschrieben, auf welche hiermit verwiesen wird.

Bei der Bezugsdrehzahl $n_0$ kann es sich um eine dem Kreiselpumpenaggregat 3, 4 extern vorgegebene Drehzahl oder um eine intern in der Steuerungselektronik 4 ermittelte Drehzahl handeln. Letztere kann beispielsweise aus einer der Drehzahlregelung vorgelagerten Kennlinienregelung stammen, die z.B. die Förderhöhe H in Abhängigkeit des Förderstroms Q gemäß einer definierten Kennlinie im sogenannten HQ-Diagramm einstellt, oder aus einer Automatikregelung resultieren, die die Förderhöhe H in Abhängigkeit anderer Kriterien einstellt, z.B. der Förderstromänderung dQ/dt.

Das Anregungssignal $f_A(t)$ kann beispielsweise ein Sinussignal der Form $f_A(t) = n_1 \cdot \sin(\omega_A \cdot t)$ sein, wobei $n_1$ die Anregungsamplitude und $\omega_A$ die Anregungsfrequenz ist. Die Anregung muss jedoch nicht zwingend sinusförmig sein. Auch eine andere periodische Signalform wie z.B. eine Rechteck-, Trapez-, Dreieck-, Sägezahn- oder Haifischflossen-Signalform sind möglich. Die periodische Anregung des Systems 1 bzw. Beaufschlagung der Bezugsdrehzahl $n_0$ mit dem Anregungssignal $f_A(t)$ erfolgt durch Überlagerung in einem Addierer 6, dem die Bezugsdrehzahl $n_0$ und das Anregungssignal $f_A(t)$ jeweils signaltechnisch zugeführt sind. Die Ausgangsgröße dieses Addierers 6 ist die modulierte Solldrehzahl $n_{soll} = n_0 + n_1 \cdot \sin(\omega_A \cdot t)$. Diese bildet die Eingangsgröße für den zweiten Verfahrensschritt II.

In diesem zweiten Verfahrensabschnitt II erfolgt die an sich bekannte Motorregelung 7 zur Einstellung der modulierten Solldrehzahl $n_{soll}$, beispielsweise unter Verwendung einer vektoriellen, insbesondere feldorientierten Regelung. Da die Istdrehzahl $\omega_{real}$ in diesem Fall die Regelgröße ist, steht sie aus der feldorientierten Regelung unmittelbar zur Verfügung, entweder aufgrund einer Messung mittels Drehgeber (Encoder), durch Auswertung der vom Rotormagnetfeld in die Statorspulen rückinduzierten Spannung (back EMF) oder aufgrund einer Berechnung mit Hilfe eines bekannten Algorithmus zur sensorlosen Drehzahlregelung. Die Motorregelung 7 umfasst zumindest einen Drehzahlregler 8, dem die modulierte Solldrehzahl $n_{soll}$ zugeführt wird und der das zur Erreichung der modulierten Solldrehzahl $n_{soll}$ erforderliche Drehmoment $T_{mot}$ in Abhängigkeit der Abweichung der Istdrehzahl $\omega_{real}$ von der Solldrehzahl $n_{soll}$ bzw. natürlich $\omega_{soll}$ bestimmt. Die Istdrehzahl $\omega_{real}$ ist somit ebenfalls eine Eingangsgröße des Drehzahlreglers 8. Der Drehzahlregler 8 kann beispielsweise ein P, PI oder PID-Regler sein, wobei das Drehmoment $T_{mot}$ die Stellgröße ist. Er kann auch ein PI-R Regler sein, der einen Resonanzanteil bei der Anregungsfrequenz $\omega_A$ besitzt, um eine möglichst geringe Regelabweichung zu erzielen.

Das ermittelte Drehmoment $T_{mot}$ wird anschließend von der Motorregelung 7 an der Antriebseinheit der Kreiselpumpe 3 eingestellt, welche in Figur 2 eine physische Systemkomponente bildet. Es resultiert in Abhängigkeit dieses Drehmoments $T_{mot}$ eine entsprechende (Ist-)Drehzahl $\omega_{real}$ der Kreiselpumpe 3 welche daraufhin eine Förderhöhe $H_{real}$ sowie in Abhängigkeit der Last 5 in Gestalt des hydraulischen Widerstands $R_{hyd}$ einen entsprechenden Förderstrom $Q_{real}$ erzeugt. Die ermittelte Istdrehzahl $\omega_{real}$, ist dem Drehzahlregler 8 zugeführt, um die Abweichung zur Solldrehzahl $n_{soll}$ zu bestimmen und das Drehmoment $T_{mot}$ anzupassen. Eine derartige Motorregelung 7 ist an sich bekannt.

Erfindungsgemäß wird das ermittelte Drehmoment $T_0$ außerdem einem mathematischen Pumpen-Motor-Modell 9 zugeführt, welches das hydromechanische Verhalten der Kreiselpumpe 3 nachbildet. Dies ist ein dritter Abschnitt III des erfindungsgemäßen Verfahrens und Teil einer modellbasierten Betriebspunktbestimmungseinrichtung 13, die in der Steuerungselektronik 4 implementiert ist und eingerichtet ist, die Förderhöhe $H_{mdl}$ und/ oder den Förderstrom $Q_{mdl}$ der Kreiselpumpe 3 aus dem Pumpen-Motor-Modell 9 zu ermitteln. Regelungstechnisch stellt dieses Pumpen-Motor-Modell 9 einen sogenannten Beobachter dar, der idealerweise eine Beobachtung sämtlicher Zustandsgrößen der Kreiselpumpe 3, also auch nicht-messbarer Zustandsgrößen ermöglicht. Insbesondere ermöglicht das Pumpen-Motor-Modell 9 eine Schätzung der aktuellen Förderhöhe $H_{real}$, des aktuellen Förderstroms $Q_{real}$ und der Istdrehzahl $\omega_{real}$ in Gestalt ihrer jeweiligen Modellgröße $H_{mdl}$, $Q_{mdl}$ und $\omega_{mdl}$, wobei letztere auch als Modelldrehzahl $\omega_{mdl}$ bezeichnet wird.

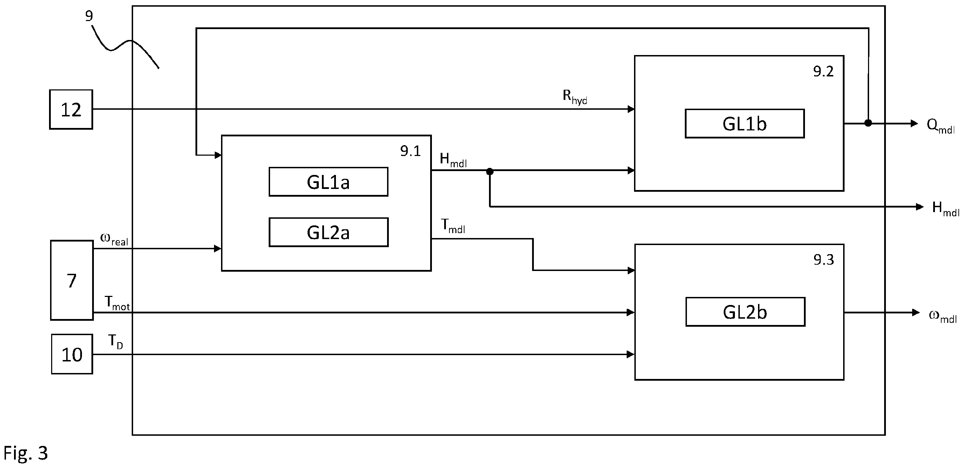

Eine Ausführungsvariante des Pumpen-Motor-Modells 9 ist in Figur 3 veranschaulicht. Es besteht aus einem Gleichungssystem basierend auf einer ersten [Gl1a, Gl1b] und einer zweiten [Gl2a, Gl2b] Differenzialgleichung, die zur Vereinfachung ihrer Berechnung jeweils in eine Integralform umgeformt sind, so dass sie eine erste und eine zweite Integralgleichung bilden. Die erste Integralgleichung [Gl1a, Gl1b] basiert auf einer hydraulischen Differentialgleichung, die eine Druckbilanz im System 1, ausgedrückt in Förderhöhen beschreibt. Sie bildet eine Volumenstromgleichung, da sie die Berechnung des Förderstroms $Q_{mdl}$ ermöglicht. Die zweite Integralgleichung [Gl2a, Gl2b] basiert auf einer hydromechanischen Differentialgleichung, die eine Drehmomentbilanz im System 1 unter Berücksichtigung von Reibungsverlusten beschreibt. Sie bildet eine Geschwindigkeitsgleichung, da sie die Berechnung der Modelldrehzahl $\omega_{mdl}$ ermöglicht. Die beiden Integralgleichungen werden nacheinander zeitdiskret mit Hilfe der Vorwärts-Euler-Integration berechnet.

Um die Auswertung der beiden Integralgleichungen zu vereinfachen, sind diese jeweils in eine statische erste Teilgleichung [Gl1a, Gl2a] (Nebengleichung) und eine dynamische zweite Teilgleichung [Gl1b, Gl2b] (Hauptgleichung) aufgeteilt, welche die Integralform besitzt. Dabei wird signaltechnisch zunächst jeweils die erste Teilgleichung [Gl1a, Gl2a] und anschließend jeweils die zweite Teilgleichung [Gl1b, Gl2b] berechnet, wobei für die Berechnung der jeweiligen zweiten Teilgleichung [Gl1b, Gl2b] das Ergebnis der Lösung der jeweiligen ersten Teilgleichung [Gl1a, Gl2a] verwendet wird, wie nachfolgend anhand von Figur 3 verdeutlicht wird, weshalb die ersten Teilgleichungen als Nebengleichungen zu den zweiten Teilgleichungen betrachtet werden können, die wiederum aufgrund ihrer Integralform die Hauptgleichungen bilden.

Insgesamt besteht das Gleichungssystem somit aus den folgenden vier Teilgleichungen Gl1a, Gl1b, Gl2a, Gl2b, wobei die ersten beiden Teilgleichungen Gl1a, Gl1b einen die erste Integralgleichung beschreibenden Satz bilden, und die zweiten beiden Teilgleichungen Gl2a, Gl2b einen die zweite Integralgleichung beschreibenden Satz bilden. In der zeitdiskreten Implementierung lauten die Teilgleichungen

$$\text{Gl1a:}\quad H_{mdl}(k) = a\omega^2(k) - bQ_{mdl}(k)\omega(k) - cQ_{mdl}^2(k)$$

$$\text{Gl1b:}\quad Q_{mdl}(k+1) = Q_{mdl}(k) + \frac{1}{L_{hyd}}\big(H_{mdl}(k) - R_{hyd}Q_{mdl}^2(k) - H_{static}(k)\big)\cdot\Delta t$$

$$\text{Gl2a:}\quad T_{mdl}(k) = a_t Q_{mdl}(k)\omega(k) - b_t Q_{mdl}^2(k) - c_t\frac{Q_{mdl}^3(k)}{\omega(k)} + v_i\omega^2(k) + v_s\omega(k)$$

$$\text{Gl2b:}\quad \omega_{mdl}(k+1) = \omega_{mdl}(k) + \frac{1}{J}(T_{mot}(k) - T_{mdl}(k) + T_D(k))\cdot\Delta t$$

wobei

| | |
|---|---|
| $H_{mdl}$ | die zu ermittelnde Förderhöhe $H_{mdl}$ der Kreiselpumpe 3, |
| $Q_{mdl}$ | der zu ermittelnde Förderstrom der Kreiselpumpe 3, |
| $\omega$ | eine Drehzahl bzw. Drehfrequenz der Kreiselpumpe ($\omega = 2\pi n$), |
| $\omega_{mdl}$ | die Modelldrehzahl der Kreiselpumpe 3, |
| $a, b, c$ | Parameter sind, die das hydraulische Pumpenkennfeld (H(Q, $\omega$)) anhand von Pumpenkurven beschreiben, |
| $R_{hyd}$ | der hydraulische Widerstand des hydraulischen Systems 1, |
| $L_{hyd}$ | die hydraulische Induktivität des hydraulischen Systems 1 und |
| $H_{static}$ | eine geodätische Förderhöhe, |
| $T_{mdL}$ | das zu berechnende theoretischen Pumpendrehmoment der Kreiselpumpe 3, |
| $T_{mot}$ | das mechanische Drehmoment des Motors (Motormoment) der Kreiselpumpe, |
| $T_D$ | ein berechnetes Störsignal in Form eines Moments (Störmoment), |
| $a_t, b_t, c_t$ | Parameter sind, die das statische Drehmomentkennfeld (T(Q, $\omega$)) der Kreiselpumpe 3 anhand von Drehmomentkurven beschreiben, |
| $v_i$ | eine die Reibung zwischen Laufrad und Medium beschreibende Größe, |
| $v_s$ | eine die Lagerreibung beschreibende Größe, |
| $J$ | die Massenträgheit der rotierenden Komponenten der Kreiselpumpe 3 (Laufrad, Welle, Rotor), und |
| k | ein diskreter Zeitpunkt und |
| $\Delta t$ | das zeitliche Intervall zwischen einem Zeitpunkt k und dem nächsten Zeitpunkt k+1 ist. |

In der ersten Teilgleichung GI1a der ersten Integralgleichung können gegebenenfalls weitere Druckterme berücksichtigt werden, um das Pumpen-Motor-Modell 9 weiter an die Realität anzupassen. Ferner können in der ersten Teilgleichung GI2a der zweiten Integralgleichung GI2 gegebenenfalls weitere Terme (z.B. für Reibung) berücksichtigt werden.

Das Pumpen-Motor-Modell 9 in Figur 3 umfasst drei Funktionsblöcke 9.1, 9.2, 9.3. In dem zweiten Funktionsblock 9.2 erfolgt die Auswertung der Hauptgleichung GI1b der ersten Integralgleichung (Volumenstromgleichung). Ferner erfolgt in dem dritten Funktionsblock 9.3 die Auswertung der Hauptgleichung GI2b der zweiten Integralgleichung (Geschwindigkeitsgleichung). Dem zweiten und dritten Funktionsblock 9.2, 9.3 signaltechnisch vorgelagert, ist der erste Funktionsblock 9.1, in welchem die beiden Nebengleichungen GI1a, GI2a (Druck und Drehmomentkennlinien) der Integralgleichungen ausgewertet werden. Die funktionale Zusammenfassung der Berechnung dieser beiden Teilgleichungen GI1a, GI2a im ersten Funktionsblock 9.1 erfolgt hier deshalb, weil beide Teilgleichungen GI1a und GI2a die aktuelle Drehzahl $\omega$ und den Förderstrom Q benötigen, um berechnet werden zu können. Ebenso gut könnten die Teilgleichungen GI1a und GI2a signaltechnisch aber auch in separaten Funktionsblöcken berechnet werden.

Die erste Teilgleichung GI1a der ersten Integralgleichung (Volumenstromgleichung) beschreibt den drehzahlabhängigen Zusammenhang zwischen Förderstrom Q und Förderhöhe H genauer gesagt das Pumpenkennfeld, d.h. für jede Drehzahl $\omega$ die Abhängigkeit der Förderhöhe H vom Förderstrom Q, wobei dieser Zusammenhang als Pumpenkurve H$\omega$(Q) bezeichnet wird. Entlang einer solchen Pumpenkurve H$\omega$(Q) ist die Drehzahl $\omega$ konstant. Die Gesamtheit aller Pumpenkurven H$\omega$(Q) bildet das Pumpenkennfeld H($\omega$, Q). Das Pumpenkennfeld H($\omega$, Q) wird üblicherweise werksseitig vermessen und in der technischen Dokumentation eines Kreiselpumpenaggregats 3 angegeben. Die das Pumpenkennfeld H($\omega$, Q) mathematisch beschreibenden Modellparameter a, b, c, sind somit bekannt.

Zur Berechnung der Modellgröße $H_{mdl}$ mittels der Teilgleichung GI1a im ersten Funktionsblock 9.1 werden somit die Drehzahl $\omega$ und der Förderstrom Q benötigt. In der Ausführungsvariante gemäß Figuren 2 und 3 wird die Drehzahl $\omega$ als Istdrehzahl $\omega_{real}$ von der Motorregelung 7 bereitgestellt bzw. dem ersten Funktionsblock 9.1 zugeführt. Als Förderstrom Q wird der berechnete Förderstrom $Q_{mdl}$ vom Ausgang des zweiten Funktionsblocks 9.2 verwendet und ebenfalls dem ersten Funktionsblock 9.1 zugeführt, wobei der Förderstrom $Q_{mdl}$ zu Beginn des Verfahrens null ist oder ein definierter Initialwert verwendet wird. Die berechnete Modellgröße $H_{mdl}$ wird am Ausgang des ersten Funktionsblocks 9.1 ausgegeben und bildet somit auch die erfindungsgemäß zu ermittelnde Förderhöhe $H_{mdl}$, die am Ausgang des Pumpen-Motor-Modells 9 als erste Ausgangsgröße ausgegeben wird.

Außerdem wird die berechnete Förderhöhen-Modellgröße $H_{mdl}$ an den zweiten Funktionsblock 9.2 übergeben, in welchem sie zur Berechnung des Förderstroms $Q_{mdl}$ mittels der zweiten Teilgleichung GI1b der ersten Integralgleichung verwendet wird. Zur Auswertung dieser Teilgleichung GI1b werden außerdem der hydraulische Widerstand $R_{hyd}$, die hydraulische Impedanz $L_{hyd}$, der aktuelle Förderstrom $Q_{mdl}(k)$ und die geodätische Förderhöhe $H_{static}$ benötigt.

Die zweite Teilgleichung GI1b der ersten Integralgleichung basiert auf der hydraulischen Differentialgleichung:,

$$H(n, Q) = R_{hyd}Q^2 + L_{hyd}\frac{dQ}{dt} + H_{static}$$ , die die Anlagenkennlinie des Rohrleitungsnetzwerks 2 bzw. des hydraulischen Systems 1 beschreibt, die maßgeblich von der Stellung/ dem Öffnungsgrad der verbraucherseitigen Ventile abhängt, d.h. vom hydraulischen Widerstand $R_{hyd}$.

Die geodätische Förderhöhe $H_{static}$ ist diejenige Förderhöhe H, die mindestens erreicht werden muss, damit überhaupt ein Förderstrom (Q>0) möglich ist. In geschlossenen hydraulischen Systeme, d.h. solchen Rohrleitungsnetzen, in denen das Fördermedium zirkuliert, wie beispielsweise in einem Heizungs- oder Kühlsystem, ist die geodätische Förderhöhe $H_{static}$ null und kann in diesem Fall vernachlässigt werden. Im Falle eines offenen Systems kann die geodätische Förderhöhe $H_{static}$ beispielsweise gemessen oder an der Pumpenelektronik 4 der Kreiselpumpe durch einen Nutzer vorgegeben werden.

Unbekannt dagegen sind zunächst der hydraulische Widerstand $R_{hyd}$ und die hydraulische Impedanz $L_{hyd}$, da diese Parameter Teil des anwenderseitigen hydraulischen Systems 1 sind, das der Pumpenhersteller nicht kennt. Die hydraulische Induktivität $L_{hyd}$ ist dabei zusammen mit dem Volumenstrom ein Maß der kinetischen Energie, die in der strömenden Wassermasse gespeichert ist. Sofern das System baulich nicht verändert wird, ändert sich folglich auch die hydraulische Impedanz $L_{hyd}$ nicht. Sie kann in der Ausführungsvariante gemäß Figuren 2 und 3 durch eine einfache Abschätzung ermittelt werden. Dagegen ändert sich der hydraulische Widerstand $R_{hyd}$ dynamisch im Betrieb des Systems 1 in Abhängigkeit des Bedarfs der Verbraucher, insbesondere des Wärme- bzw. Kältebedarfs, d.h. in Abhängigkeit der Stellung der verbraucherseitigen Stellventile, die den Volumenstrom durch die Verbraucher einstellen. Wenn die Ventile komplett schließen, ändert sich allerdings auch die Induktivität $L_{hyd}$.

Der hydraulische Widerstand $R_{hyd}$ ist in der ersten Ausführungsvariante ein Modellparameter des Pumpen-Motor-Modells 9, der erfindungsgemäß dynamisch angepasst wird. Er wird von einem Parameterregler 12 wiederholt neu ermittelt und dem Pumpen-Motor-Modells 9, genauer gesagt dem zweiten Funktionsblock 9.2 zugeführt, um in Teilgleichung GI1b verwendet zu werden. Da der hydraulische Widerstand $R_{hyd}$ zu Beginn des Verfahrens unbekannt ist, kann für $R_{hyd}$ ein beliebiger Initialwert verwendet werden. Denn im Laufe des Verfahrens wird sein Wert vom Parameterregler 12 hin zum realen Wert korrigiert, wie im Folgenden noch erläutert wird.

Bei dem in Gleichung GI1b zu verwendenden Volumenstromwert Q handelt es sich um denjenigen Volumenstromwert, der zum aktuellen Zeitpunkt k gültig ist. Teilgleichung GI1b kann somit ausgewertet und der neue Volumenstrom $Q_{mdl}(k+1)$ ermittelt werden. Er stellt somit das Ausgangssignal des zweiten Funktionsblocks 9.2 sowie die zweite Ausgangsgröße des Pumpen-Motor-Modells 9 dar.

Der erste Teil GI2a der zweiten Integralgleichung (Geschwindigkeitsgleichung) beschreibt den drehzahlabhängigen Zusammenhang zwischen Drehmoment T und Förderstrom Q. Es handelt sich somit im Grunde um eine Momentengleichung. Sie benötigt, wie Teilgleichung GI1a, die aktuelle Drehzahl $\omega(k)$ und den aktuellen Förderstrom Q(k). Wie zur Einzelgleichung GI1a erläutert, wird als Drehzahl $\omega$ die von der Motorregelung 7 dem ersten Funktionsblock 9.1 zugeführte Istdrehzahl $\omega_{real}$ und als aktueller Förderstrom Q(k) der zuletzt mit Teilgleichung GI1b berechnete Förderstrom $Q_{mdl}(k+1)$ vom Ausgang des zweiten Funktionsblocks 9.2 verwendet.

Der Term $v_i\omega^2$ in Teilgleichung GI2a beschreibt die Reibung zwischen Laufrad und Medium, der Term $v_s\omega$ Lagerreibungsverluste, die aus der Lagerung der Pumpen- bzw. Motorwelle resultieren. Beide Größen $v_i$ und $v_s$ können werksseitig durch Vermessung der Kreiselpumpe ermittelt werden und sind insoweit bekannt. Weiterhin beschreibt der Term $I\frac{\mathrm{d}Q}{\mathrm{d}t}$ das Trägheitsmoment des Mediums im Laufrad. Aufgrund der vergleichsweise geringen Menge an Fördermedium im Laufrad ist der Term $I\frac{\mathrm{d}Q}{\mathrm{d}t}$ vergleichsweise klein und kann vernachlässig werden.

Die Modellparameter at, bt und ct beschreiben den physikalischen Zusammenhang zwischen dem Drehmoment T, Förderstrom Q und der Drehzahl $\omega$, mit anderen Worten das aus den einzelnen Drehmomentkurven $T_\omega(Q)$ gebildete Drehmomentkennfeld $T(\omega, Q)$ der Kreiselpumpe 3, wobei entlang einer Drehmomentkurve $T_\omega(Q)$ die Drehzahl $\omega$ konstant ist. Da, wie zuvor bereits gesagt, jedes Pumpenaggregat herstellerseitig vermessen wird und dessen hydraulisches und hydromechanisches Pumpenkennfeld dem Hersteller bekannt sind, sind auch die Modellparameter at, bt und ct an sich bekannt. Der Modellparametern ct ist im vorliegenden Beispiel ein Wert, der sich mit der Zeit ändern kann. Sein Anfangswert kann ebenfalls werksseitig durch Vermessung der Kreiselpumpe 3 ermittelt werden.

Die berechnete Modellgröße $T_{mdL}$ wird am Ausgang des ersten Funktionsblocks 9.1 ebenfalls ausgegeben und an den dritten Funktionsblock 9.3 übergeben, in welchem sie zur Berechnung der Modelldrehzahl $\omega_{mdl}$ mittels der zweiten Teilgleichung GI2b der zweiten Integralgleichung verwendet wird. Zur Auswertung dieser Teilgleichung GI2b wird außerdem das Trägheitsmoment J, das Motormoment $T_{mot}$ und der Wert eines Störmoments $T_D$ benötigt, das im Falle einer Abweichung der Modell- von der Istdrehzahl existiert, d.h. betraglich größer null ist. Das Trägheitsmoment J der rotierenden Komponenten (Welle, Rotor, Laufrad) der Kreiselpumpe 3 kann ebenfalls werksseitig durch Vermessung der Kreiselpumpe 3 ermittelt oder aus Konstruktionsdaten berechnet werden. Das Motormoment $T_{mot}$ wird dem Pumpen-Motor-Modell 9 respektive dem dritten Funktionsblock 9.3 von der Motorregelung 7 zugeführt. Weiterhin wird das Störmoment $T_D$ von einem Störregler 10 ermittelt und ebenfalls dem Pumpen-Motor-Modell 9 respektive dem dritten Funktionsblock 9.3 zugeführt.

Teilgleichung GI2b kann somit ausgewertet und die Modelldrehzahl $\omega_{mdl}$ ermittelt werden. Sie stellt somit das Ausgangssignal des dritten Funktionsblocks 9.3 sowie die dritte Ausgangsgröße des Pumpen-Motor-Modells 9 dar.

Die Gleichungen des Pumpen-Motor-Modells 9 werden fortlaufend wiederholt berechnet, insbesondere je nach Taktrate des Prozessors der Steuerungselektronik 4, auf dem diese Berechnung erfolgt. Dabei wird in jedem Takt ein neuer Förderstromwert $Q_{mdl}(k+1)$ bzw. Drehzahlwert $\omega_{mdl}(k+1)$ aus dem im vorherigen Takt verwendeten Förderstromwert $Q_{mdl}(k)$ bzw. Drehzahlwert $\omega_{mdl}(k)$ berechnet.

Mit Hilfe des Pumpen-Motor-Modells 9 (Beobachters) wird die aktuelle Drehzahl der Kreiselpumpe 3 als Modelldrehzahl $\omega_{mdl}$ geschätzt und einem Störungsregler 10 zugeführt, der ebenfalls die Istdrehzahl $\omega_{real}$ der Kreiselpumpe 3 erhält. Der Störungsregler 10 bildet einen vierten Verfahrensabschnitt IV, vergleiche Figur 2. Er ermittelt zunächst, ob und in welcher Höhe eine Abweichung der Modelldrehzahl $\omega_{mdl}$ von der Istdrehzahl $\omega_{real}$ vorliegt, und bestimmt aus dieser Abweichung ein Störungssignal $T_D$. Der Störungsregler 10 bildet insoweit eine Störungssignal-Berechnungseinheit. Er ist dafür zuständig, die Modelldrehzahl $\omega_{mdl}$ so einzustellen bzw. zu regeln, dass sie der realen Drehzahl $\omega_{real}$ entspricht.

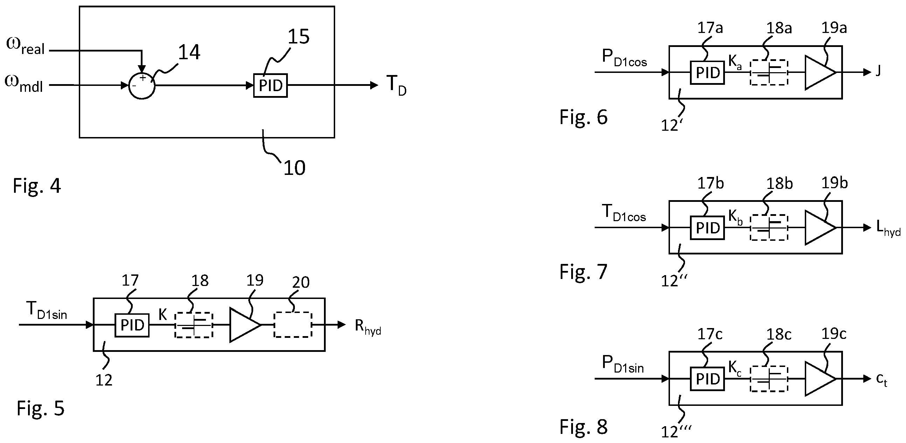

Eine erste Ausführungsvariante des Störungsreglers 10 ist in Figur 4 dargestellt. Er umfasst einen Subtrahierer 14, der die Abweichung ($\omega_{real} - \omega_{mdl}$) der Modelldrehzahl $\omega_{mdl}$ von der Istdrehzahl $\omega_{real}$ des Kreiselpumpenaggregats 3, 4 berechnet. Dieser Teil des Störungsreglers 10 kann zusammen mit dem Pumpen-Motor-Modell 9 als "Drehmomentbeobachter" verstanden werden, weil eine Abweichung der Modelldrehzahl $\omega_{mdl}$ von der Istdrehzahl $\omega_{real}$ eine Abweichung des Modells 9 von der Realität bedeutet, die sich in einem Störmoment manifestiert, das wiederum für die Drehzahlabweichung verantwortlich ist. Des Weiteren umfasst der Störungsregler 10 einen Regler 15 mit einem Integralanteil, der hier als PID-Regler ausgebildet ist. Die berechnete Abweichung bzw. Drehzahldifferenz wird diesem Regler 15 zugeführt und aufgrund des Integralanteils integriert. Die physikalische Größe des Reglerausgangs wird durch die angeschlossene Stellgröße definiert, so dass das Reglerausgangssignal (Stellgröße des Reglers) physikalisch betrachtet einem Drehmoment entspricht.

In der ersten Ausführungsvariante des Störungsreglers 10 bildet das Reglerausgangssignal unmittelbar das Störungssignal $T_D$, welches entsprechend als Störmoment $T_D$ betrachtet werden kann. Unterscheiden sich die Drehzahlen $\omega_{mdl}$, $\omega_{real}$, dann stimmt das Pumpen-Motor-Modell 9 nicht mit der Realität überein. Somit kann der Störungsregler 10 auch als "Störungsbeobachter" bezeichnet werden. Das Störmoment $T_D$ beschleunigt die Modelldrehzahl $\omega_{mdl}$, wenn sie geringer als die Istdrehzahl $\omega_{real}$ ist, und bremst die Modelldrehzahl $\omega_{mdl}$, wenn sie größer als die Istdrehzahl $\omega_{real}$ ist. Das Störungssignal $T_D$ kompensiert auf diese Weise eine Abweichung des Pumpen-Motor-Modells 9 von der Realität. Eine solche Abweichung kann beispielsweise durch ungenaue Parameterwerte bedingt sein, allerdings auch aufgrund externer Störeinflüsse bestehen, wie z.B. Drehmomentfluktuationen aufgrund von Partikeln oder Blasen im gepumpten Medium oder aufgrund von sich ändernder Lagerreibung.

Der PID-Regler 15 des Störungsreglers 10 wird mit dem Wert 0 initialisiert. Sind die Drehzahlen $\omega_{real}$ und $\omega_{mdl}$ identisch, ist deren Abweichung null und das Störungssignal $T_D$ (Störmoment) konstant bzw. zu Beginn des Verfahrens ebenfalls gleich null. Ergibt sich eine negative Abweichung zwischen den Drehzahlen $\omega_{mdl}$ und $\omega_{real}$, d.h. dass die Istdrehzahl $\omega_{real}$ hinter der Modelldrehzahl $\omega_{mdl}$ zurückbleibt, fällt das Störungssignal $T_D$. Dies kann dahingehend interpretiert werden, dass in der Realität ein Störmoment (Bremsmoment) wirkt, wodurch die Kreiselpumpe 3 tatsächlich eine geringere Drehzahl $\omega_{real}$ hat, als sie das Pumpen-Motor-Modells 9 schätzt. Mit anderen Worten wirken in der Realität Verluste (z.B. Reibungsverluste/ Lagerverschleißt, höherer hydraulischer Widerstand, höhere Trägheitskraft etc.), die im (idealisierten) Pumpen-Motor-Modell 9 unberücksichtigt sind, so dass das Pumpen-Motor-Modell 9 die Modelldrehzahl $\omega_{mdl}$ zu hoch schätzt. Ergibt sich eine positive Abweichung zwischen den Drehzahlen $\omega_{mdl}$ und $\omega_{real}$, d.h. dass die Modelldrehzahl $\omega_{mdl}$ kleiner als die Istdrehzahl $\omega_{real}$ geschätzt wird, steigt das Störungssignal $T_D$ infolge des I-Anteils des Reglers 15 stetig. Eine zu geringe Modelldrehzahl $\omega_{mdl}$ kann dann vorliegen, wenn das Pumpen-Motor-Modell 9 das Kreiselpumpenaggregat 3, 4 samt angeschlossenem System 1 zu verlustbehaftet modelliert, gegebenenfalls überangepasst ist.

Das Störungssignal $T_D$ wird anschließend einer Auswerteeinheit 11 zugeführt und darin ausgewertet, was einen fünften Verfahrensabschnitt V darstellt. Die Auswerteeinheit 11 gemäß Figur 2 ist eingerichtet, aus dem Störungssignal $T_D$ ein Korrektursignal $T_{D1sin}$ zu bestimmen. Dies erfolgt derart, dass das Störungssignal $T_D$ zunächst mit einem Sinussignal multipliziert wird, dessen Frequenz dem Einfachen der Anregungsfrequenz $\omega_A$, d.h. der Grundfrequenz des Anregungssignals fA(t) entspricht. Das so gebildete Produkt wird anschließend über wenigstens eine Periode T des Anregungssignals $f_A(t)$ integriert, um das Korrektursignal $T_{D1sin}$ zu erhalten. Mathematisch betrachtet, handelt es sich dabei um eine SinusTransformation. Die Bestimmung des Korrektursignals $T_{D1sin}$ kann somit wie folgt erfolgen:

$$T_{D1sin} = \frac{1}{T} \int_t^{t+T} T_D(t) \cdot \sin(\omega_A t)\,\mathrm{d}t$$

Das Korrektursignal $T_{D1sin}$ wird anschließend einem Parameterregler 12 zugeführt, der eingerichtet ist, eine Anpassung eines Modellparameters in Abhängigkeit des Korrektursignals $T_{D1sin}$ durchzuführen. Der anzupassende Modellparameter ist in der Ausführungsvariante gemäß Figur 2 (nur) der hydraulische Widerstand $R_{hyd}$ des Rohrleitungsnetzwerks 2.

Eine erste Ausführungsvariante des Parameterreglers 12 ist in Figur 5 dargestellt. Er umfasst einen Regler 17 mit Integralanteil, dem das Korrektursignal $T_{D1sin}$ zugeführt wird. Der Regler 17 ist hier als PID-Regler implementiert. Das Ausgangssignal dieses Reglers 17 stellt einen Korrekturfaktor K dar. Der Regler 17 wird zu Beginn des Verfahrens mit dem Wert 1 initialisiert, so dass der Korrekturfaktor K zunächst den Wert 1 hat. Der Parameterregler 12 umfasst ferner einen Multiplizierer 19, der den Korrekturfaktor K mit einem Initialwert des Modellparameters $R_{hyd}$ multipliziert. Bei einem Korrekturfaktor K=1, wird der Initialwert folglich nicht korrigiert, so dass der Modellparameter $R_{hyd}$ dem Initialwert entspricht. Ist das Korrektursignal $T_{D1sin}$ null bleibt der Korrekturfaktor K unverändert. Bei einem Korrektursignal $T_{D1sin}$ größer null wird der Korrekturfaktor K infolge des Integralanteil des Reglers 17 erhöht. Ist das Korrektursignal $T_{D1sin}$ kleiner als null wird der Korrekturfaktor K infolge der Integration des Korrektursignals $T_{D1sin}$ verringert. Der Modellparameter $R_{hyd}$ wird folglich durch den Parameterregler 12 dynamisch angepasst, insbesondere "geregelt", wobei der Korrekturfaktor K als eine Stellgröße angibt, wie groß die Abweichung des Modellparameters $R_{hyd}$ vom Initialwert ist.

Der Korrekturfaktor K ermöglicht es somit im Allgemeinen, weitere Informationen über das Kreiselpumpenaggregat 3, 4 oder das Rohrleitungsnetzwerk 2 zu gewinnen, wie beispielsweise eine Information über Alterung/ Verschleiß der Kreiselpumpe 3, Ablagerungen am Laufrad (Verockerung) oder eine Störung im Rohrleitungsnetzwerk. Hierdurch wird eine Zustandsüberwachung der Kreiselpumpe 3, 4 möglich. Übersteigt oder unterschreitet der Korrekturfaktor K einen vorbestimmten Grenzwert, kann eine Fehlermeldung, ein Warn- und/ oder Wartungshinweis ausgegeben werden.

Der Parameterregler 12 kann des Weiteren eine Korrekturfaktor-Begrenzung 18 aufweisen, die den Korrekturfaktor K auf einen oberen und/ oder unteren Grenzwert limitiert, beispielsweise auf den oberen Wert 5 oder auf den unteren Wert 1/5, so dass der zulässige Wertebereich für den anzupassenden Modellparameter bei maximal dem Fünffachen und einem Fünftel des Initialwertes liegt. Die Korrekturfaktor-Begrenzung 18 liegt somit signaltechnisch zwischen dem Regler 17 und dem Multiplizierer 19. Die Korrekturfaktor-Begrenzung 18 verhindert, dass sich das Modell 9 z.B. aufgrund von vorübergehend falschen Messwerten zu weit vom realen System weg bewegt. Denn liegt z.B. ein Förderstrom Q = 0 vor, müsste der Widerstand $R_{hyd}$ unendlich groß sein. D.h., dass dieser Zustand durch Integration nie erreicht werden würde. Umgekehrt würde es dann auch sehr lange dauern, aus dem Unendlichen wieder in einen anderen Betriebspunkt zurückzukehren. Da sich bei sehr geringen Volumenströmen das Ergebnis aber auch nicht mehr signifikant ändert, ist es sinnvoll den Widerstand $R_{hyd}$ zu begrenzen. Auch bei anderen Modellparametern kann angenommen werden, dass sie sich nur in einem bestimmten Bereich ändern können. Andernfalls liegt gegebenenfalls ein anderer Fehler, z.B. ein Messfehler vor.

Des Weiteren kann der Parameterregler 12 eine Linearisierungseinheit 20 aufweisen, so dass der Parameterregler 12 ein gleiches Verhalten bei Erhöhung wie bei Reduzierung zeigt und das Störsignal TD1 sin proportional zur Volumenstromänderung wird.

Der von dem Parameterregler 12 gegebenenfalls angepasste Modellparameter $R_{hyd}$ wird anschließend dem Pumpen-Motor-Modell 9 zugeführt. Das Pumpen-Motor-Modell 9 verwendet den angepassten Modellparameter dann im zweiten Funktionsblock 9.2 dazu, den Förderstrom $Q_{mdl}$ zu berechnen.

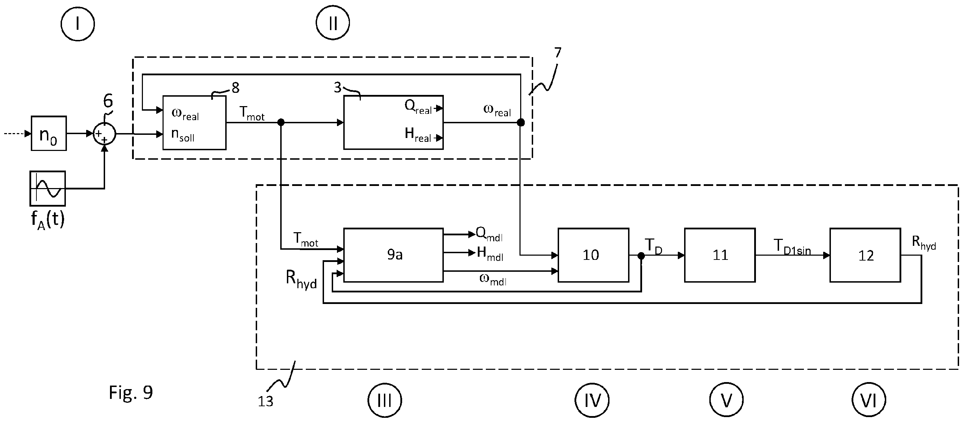

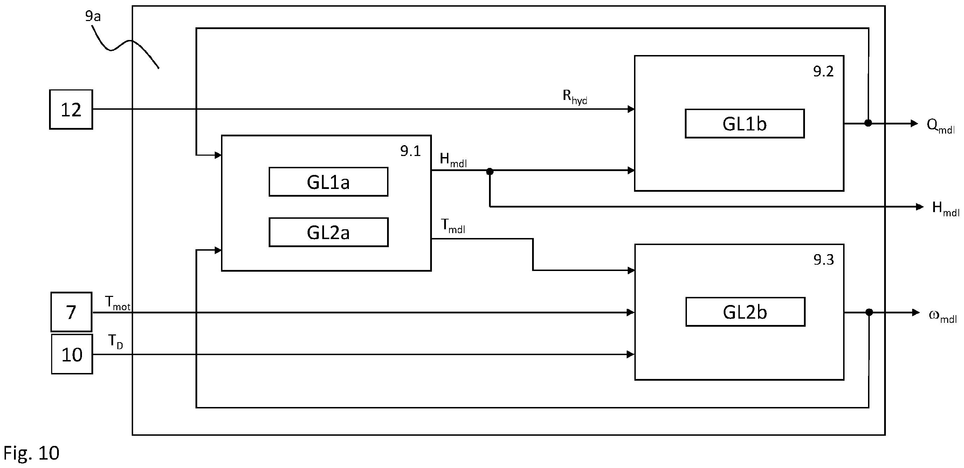

Figur 9 und 10 zeigen eine zweite Ausführungsvariante des Pumpen-Motor-Modells 9a. Es unterscheidet sich von der ersten Ausführungsvariante darin, dass dem Pumpen-Motor-Modell 9a keine Istdrehzahl $\omega_{real}$ von der Motorregelung 7 zugeführt wird. Stattdessen wird im Pumpen-Motor-Modell 9a bei den Einzelgleichungen GI1a, GI2a die im vorherigen Zyklus intern berechnete Modelldrehzahl $\omega_{mdl}$ verwendet, wofür der Ausgang des dritten Funktionsblocks 9.3 auf den Eingang des ersten Funktionsblocks 9.1 zurückgeführt ist, siehe Figur 10. Dies ist möglich, weil der Störungsregler 10 einen etwaigen Drehzahlfehler sehr gut auszuregeln vermag.

Die einzelnen Abschnitte I-VI des erfindungsgemäßen Verfahrens, die auch als Funktionsabschnitte betrachtet werden können, sind in der nachfolgenden Tabelle noch einmal zusammengefasst:

| Verfahrensabschnitt | Funktionsblock | Funktion |
|---|---|---|
| I | Drehzahlvorgabe | Periodische Anregung einer Bezugsdrehzahl |
| II | Motorregelung | Drehzahlregelung und Bestimmung der Istdrehzahl und des Drehmoments |
| III | Pumpen-Motor-Modell | Berechnung/ Beobachtung von Drehzahl, Förderhöhe und Förderstrom |
| IV | Störungsregler | Berechnung eines Störungssignals; Regler mit hoher Bandbreite, bzw. einer Bandbreite von mindestens einer Dekade über der Anregungsfrequenz; stellt sicher, dass Modelldrehzahl der Istdrehzahl entspricht |
| V | Auswerteeinheit | Berechnung eines oder mehrerer Korrektursignale aus dem Störungssignal |
| VI | Parameterregler | Modellparameteranpassung in Abhängigkeit des Korrektursignals |

Durch dieses Verfahren wird die Genauigkeit der Förderstrom- und/ oder Förderhöhenermittlung verbessert, da jedem Störmoment $T_D$ durch den Störungsregler 10 und die diesem nachfolgende Parameteranpassung im Parameterregler 12 entgegengewirkt und dadurch das Rauschen im Förderstrom- und/ oder Förderhöhensignal gegenüber der Vorgehensweise im Stand der Technik reduziert wird. Somit kann die Signalqualität verbessert werden oder bei gleichbleibender Qualität bei dem Anregungssignal eine geringere Anregungsamplitude als im Stand der Technik verwendet werden bzw. eine nachfolgende Glättung durch Filterung reduziert werden, so dass eine schnellere Reaktion des Kreiselpumpenaggregats 3, 4 auf Systemzustandsänderungen oder Störungen im hydraulischen Rohrleitungsnetzwerk 2 erfolgen kann. Infolge der Anpassung des Modellparameters im Betrieb des Pumpenaggregats 3, 4 werden außerdem etwaige Ungenauigkeiten im Pumpen-Motor-Modell 9 kompensiert, die auf eine Streuung der Modellparameter in der Serienherstellung und/ oder den alterungsbedingten Verschleiß z.B. der Lager der Kreiselpumpe 3 zurückgehen können.

Für die Bestimmung des Förderstroms Q muss prinzipiell nur der hydraulische Widerstand $R_{hyd}$ nachgeführt werden, jedenfalls sofern die anderen Modellparameter aus einer Vermessung, Schätzung, Berechnung etc. bekannt sind, da $R_{hyd}$ der einzig dynamisch veränderliche Parameter ist. Gleichwohl könnte der hydraulische Widerstand $R_{hyd}$ auch auf andere Weise ermittelt und dem Pumpen-Motor-Modell 9 zugeführt werden. Das erfindungsgemäße Verfahren ist somit nicht darauf beschränkt, mit der Auswerteeinheit 11 und dem Parameterregler 12 den hydraulischen Widerstand $R_{hyd}$ nachzuführen. Vielmehr kann auch ein einzelner anderer Parameter nachgeführt werden, wie z.B. das Trägheitsmoment J, die hydraulische Impedanz $L_{hyd}$ oder der Parameter ct. Im Falle des Trägheitsmoments J ist der Parameterregler 12 in Figur 2 oder 9 durch den Trägheitsmomentregler 12' aus Figur 6, im Falle der hydraulischen Impedanz $L_{hyd}$ durch den Impedanzregler 12" aus Figur 7 und im Falle des Parameters ct durch den ct-Regler 12''' aus Figur 8 gebildet. In diesen drei genannten Fällen gibt auch die Auswerteeinheit 11 jeweils ein anderes Korrektursignal aus, wie nachfolgend noch erläutert ist.

Um jedoch die Genauigkeit der Förderstrombestimmung, insbesondere auch bei Serienstreuung (Modellparameter bei unterschiedlichen Pumpen derselben Serie können sich herstellungs- und toleranzbedingt unterscheiden) sowie über die mehrjährige Betriebszeit der Kreiselpumpe 3, 4 hinweg, d.h. bei Alterungseffekten zu verbessern, können zusätzlich zum hydraulischen Widerstand die genannten weiteren Parameter des Pumpen-Motor-Modells 9 nachgeführt werden. Darüber ist es dann auch möglich, weitere Informationen z.B. über den Verschleiß der Pumpe 3, 4 zu erhalten.

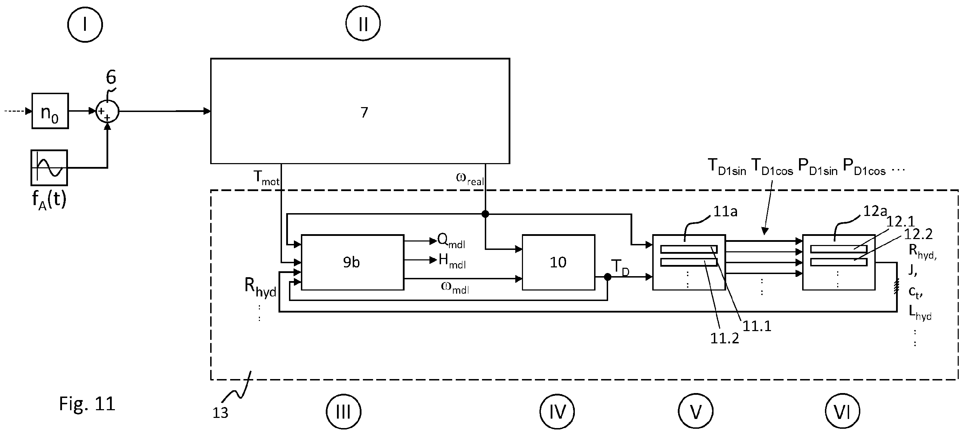

Figur 11 zeigt eine dritte Ausführungsvariante des erfindungsgemäßen Verfahrens. Sie unterscheidet sich von der ersten und zweiten Variante im Wesentlichen darin, dass die Auswerteeinheit 11a die Istdrehzahl $\omega_{real}$ erhält und mehrere Korrektursignale berechnet, wobei jedes Korrektursignal zur Anpassung eines einzelnen Modellparameters verwendet werden kann, so dass eine der Anzahl an Korrektursignalen entsprechende Anzahl an Modellparametern des Pumpen-Motor-Modells 9b gleichzeitig angepasst werden kann. Dabei wird jedes Korrektursignal in einer Korrektursignal-Berechnungseinheit 11.1, 11.2 berechnet, die alle Teil der Auswerteeinheit 11a sind. Aus der Istdrehzahl $\omega_{real}$ kann die Auswerteeinheit 11a ein zweites Störungssignal $P_D$ berechnen. Ferner kann die Auswerteeinheit 11a sowohl aus dem ersten Störungssignal $T_D$ als auch aus diesem zweiten Störungssignal $P_D$ jeweils ein oder mehrere Korrektursignale berechnen.

Die Auswerteeinheit 11a gemäß Figur 11 ist eingerichtet, eine diskrete Sinus/ Cosinus-Transformation des Störungssignals $T_D$ bzw. Störmoments $T_D$ bei der Grundfrequenz $\omega_A$ des Anregungssignals $f_A(t)$ durchzuführen. Dabei wird einerseits durch Integration des Produkts aus dem Störungssignal $T_D$ und einem Sinussignal mit der besagten Grundfrequenz $\omega_A$ ein erstes Korrektursignal $T_{D1sin}$ berechnet, das einen Wirkanteil (oder Realteil) repräsentiert und mit dem Anregungssignal $f_A(t)$ in Phase liegt, sowie ein zweites Korrektursignal $T_{D1cos}$ berechnet, das einen Blindanteil (oder Imaginärteil) repräsentiert und orthogonal zum Anregungssignal $f_A(t)$ ist. Zusätzlich kann der Gleichanteil $T_{D0}$ des Störungssignals $T_D$ als ein drittes Korrektursignal berechnet werden. Diese drei Korrektursignale können zur Adaption von drei Parametern des Pumpen-Motor-Modells 9b verwendet werden, da sie in einem nicht fehlerbehafteten Modell verschwinden würden. Mathematisch können die drei Korrektursignale $T_{D1sin}$, $T_{D1cos}$, $T_{D0}$ durch die folgenden Integrale dargestellt werden, die jeweils in einer der Korrektursignal-Berechnungseinheiten 11.1, 11.2 berechnet werden:

$$T_{D1sin} = \frac{1}{T} \int_t^{t+T} T_D(t) \cdot \sin(\omega_A t) \mathrm{d}t$$

$$T_{D1cos} = \frac{1}{T} \int_t^{t+T} T_D(t) \cdot \cos(\omega_A t) \mathrm{d}t$$

$$T_{D0} = \frac{1}{T} \int_t^{t+T} T_D(t) \mathrm{d}t$$

In gleicher Weise können sogar weitere Frequenzen angeregt und ausgewertet werden. Man erhält dadurch pro Frequenz $n\omega_A t$ zwei weitere Korrektursignale $T_{Dnsin}$, $T_{Dncos}$ aus dem ersten Störsignal $T_D$, die in entsprechenden Korrektursignal-Berechnungseinheiten 11.1, 11.2 berechnet werden können:

$$T_{Dnsin} = \frac{1}{T} \int_t^{t+T} T_D(t) \cdot \sin(n\omega_A t) \mathrm{d}t$$

$$T_{Dncos} = \frac{1}{T} \int_t^{t+T} T_D(t) \cdot \cos(n\omega_A t) \mathrm{d}t$$

Diese können zur Nachführung von zwei weiteren Modellparametern verwendet werden.

Wie bereits angesprochen, ist die Auswerteeinheit 11a außerdem eingerichtet, ein zweites Störungssignal $P_D$

zu berechnen und eine diskrete Sinus/ Cosinus-Transformation dieses zweiten Störungssignals $P_D$ bei der Grundfrequenz des Anregungssignals $f_A(t)$ durchzuführen. Hierzu wird zunächst das Produkt aus dem ersten Störungssignal bzw. dem Störmoment $T_D$ und der Istdrehzahl $\omega_{real}$ berechnet, welches eine Leistung $P_D = T_D \cdot \omega_{real}$ repräsentiert, die in Analogie zum Störmoment $T_D$ als "Störleistung" bezeichnet werden kann.

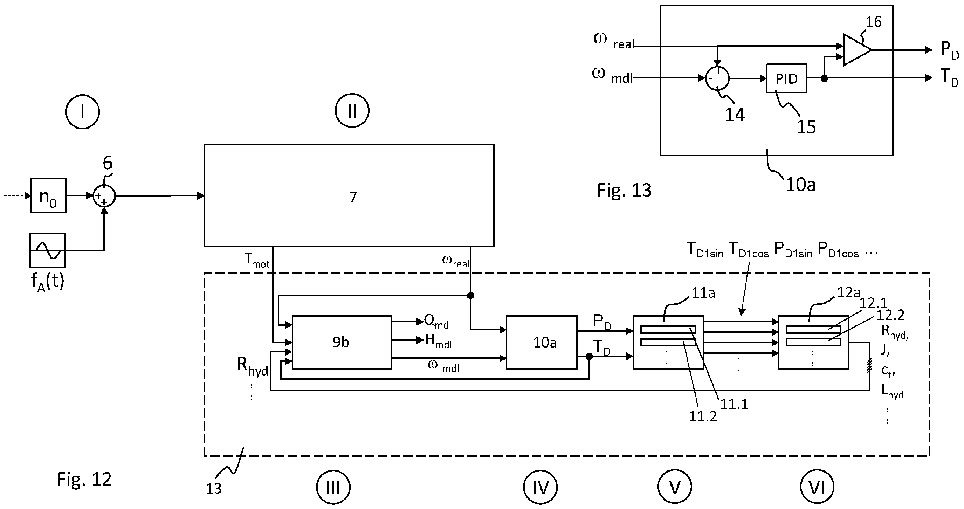

Alternativ zur Berechnung des zweiten Störungssignals $P_D$ in der Auswerteeinheit 11a, kann diese Berechnung in dem Störungsregler 10a erfolgen. Eine solche Ausführungsvariante veranschaulichen die Figuren 12 und 13. Somit muss die Istdrehzahl nicht der Auswerteeinheit zugeführt werden. Wie aus Figur 13 ersichtlich ist, umfasst der Störungsregler 10a, der in Figur 12 verwendet ist, in diesem Fall zusätzlich einen Multiplizierer 16, der das Ausgangssignal des Reglers 15, d.h. das Störmoment $T_D$, mit der Istdrehzahl $\omega_{real}$ multipliziert und somit eine Störleistung $P_D$ an seinem Ausgang zur Verfügung stellt. Das Störmoment $T_D$ ist dann das erste Störungssignal $T_D$ und die Störleistung $P_D$ das zweite Störungssignal $P_D$, welche beide von dem Störungsregler 10a an die Auswerteeinheit 11a übergeben werden, so dass diese das zweite Störungssignal $P_D$ nicht berechnen muss.

Aus dem zweiten Störungssignal $P_D$ berechnet die Auswerteeinheit 11a durch Integration des Produkts aus dem zweiten Störungssignal $P_D$ und einem Sinussignal mit der besagten Grundfrequenz $\omega_A$ ein viertes Korrektursignal $P_{D1sin}$, das einen Wirkanteil (oder Realteil) repräsentiert und mit dem Anregungssignal $f_A(t)$ in Phase liegt, sowie ein fünftes Korrektursignal $P_{D1cos}$, das einen Blindanteil (oder Imaginärteil) repräsentiert und orthogonal zum Anregungssignal $f_A(t)$ ist. Zusätzlich kann der Gleichanteil $P_{D0}$ des zweiten Störungssignals $P_D$ als sechstes Korrektursignal berechnet werden. Somit können drei weitere Korrektursignale $P_{D1sin}$, $P_{D1cos}$, $P_{D0}$ durch Bildung der folgenden Integrale bestimmt werden, was jeweils in einer der Korrektursignal-Berechnungseinheiten 11.1, 11.2 erfolgt:

$$P_{D1sin} = \frac{1}{T} \int_t^{t+T} P_D(t) \cdot \sin(\omega t) \, dt$$

$$P_{D1cos} = \frac{1}{T} \int_t^{t+T} P_D(t) \cdot \cos(\omega t) dt$$

$$P_{D0} = \frac{1}{T} \int_t^{t+T} P_D(t) dt$$

mit

$$P_D = T_D(t) \cdot \omega_{real}(t)$$

In gleicher Weise können auch hier weitere Frequenzen angeregt und ausgewertet werden. Man erhält dadurch pro Frequenz $n\omega_A t$ zwei weitere Korrektursignale $P_{Dnsin}$, $P_{Dncos}$ aus dem zweiten Störsignal $P_D$

$$P_{Dnsin} = \frac{1}{T} \int_t^{t+T} P_D(t) \cdot \sin(n\omega_A t) dt$$

$$P_{Dncos} = \frac{1}{T} \int_t^{t+T} P_D(t) \cdot \cos(n\omega_A t) dt$$

die zur Nachführung von zwei weiteren Modellparametern verwendet werden können.

Selbstverständlich muss die Auswerteeinheit 11a nicht unbedingt alle vorgenannten Korrektursignale berechnen. Dies kann vielmehr je nach Bedarf und Wunsch erfolgen.

Die von der Auswerteeinheit 11 berechneten Korrektursignale $T_{D1sin}$, $T_{D1cos}$, $P_{D1sin}$, $P_{D1cos}$, $T_{D0}$, $P_{D0}$ etc. werden anschließend dem Parameterregler 12a zugeführt, der eingerichtet ist, pro Korrektursignal einen Modellparameter anzupassen. Dies erfolgt in Einzelparameterreglern 12.1, 12.2 etc., denen jeweils ein bestimmtes Korrektursignal zugeführt ist. Somit können von diesem Parameterregler 12a sechs Modellparameter gleichzeitig angepasst werden. Der Parameterregler 12 besteht somit genauer betrachtet aus einer Anzahl von Einzelparameterreglern 12.1, 12.2, die jeweils eine Struktur wie in Figur 5, 6, 7 oder 8 aufweisen können und jeweils einen Modellparameter vorgeben. In Figur 5 ist dies der hydraulische Widerstand $R_{hyd}$, in Figur 6 die Massenträgheit J der rotierenden Komponenten der Kreiselpumpe 3, in Figur 7 die hydraulische Impedanz $L_{hyd}$ und in Figur 8 der Modellparameter ct. Der Parameterregler 12 in Figur 5 unterscheidet sich von den anderen Parameterreglern 12', 12", 12''' der Figuren 6 bis 8 lediglich darin, dass er eine Linearisierungseinheit 20 aufweist. Im Übrigen besitzt jeder Parameterregler 12, 12', 12", 12''' einen Regler 17, 17a, 17b, 17c mit Integralanteil, der z.B. als PID-Regler ausgestaltet sein kann, einen Multiplizierer 19, 19', 19", 19''', um den jeweiligen Korrekturfaktor K, $K_a$, $K_b$, $K_c$ mit dem entsprechenden Initialwert des jeweiligen Modellparameters $R_{hyd}$, J, $L_{hyd}$, ct zu multiplizieren, und optional eine Korrekturfaktor-Begrenzung 18, 18', 18", 18'''. Die Funktionsweise jedes Parameterreglers 12, 12', 12", 12''' ist wie zuvor zum ersten Ausführungsbeispiel beschrieben.

Prinzipiell kann jedes einzelne Korrektursignal für die Nachführung eines Modellparameters genutzt werden. Dabei ist allerdings zu beachten, dass Signale, die einen Wirkanteil repräsentieren, d.h. Signale die mit der Anregung der Pumpendrehzahl in Phase liegen -bei sinusförmiger Anregung also die Sinussignale -jene Modellparameter anpassen, die vorwiegend auf die Wirkleistung wirken. Dies ist bei dem hydraulischen Widerstand $R_{hyd}$ und dem Modellparameter ct der Fall, weshalb den Parameterreglern 12, 12''' für diese Modellparameter in Figuren 5 und 8 die Korrektursignale $T_{D1sin}$ und $P_{D1sin}$ zugeführt werden. Allerdings kommt es nicht darauf an, welcher dieser Parameterregler 12, 12''' das Korrektursignal $T_{D1sin}$ und welcher das Korrektursignal $P_{D1sin}$ erhält. Die Korrektursignalzuführung ist insoweit vertauschbar.

Demgegenüber sollten jene Korrektursignale, die eine Blindleistung repräsentieren, d.h. 90° Phasenverschoben zur Anregung der Pumpendrehzahl sind, also die zuvor genannten Korrektursignale $T_{D1cos}$ und $P_{D1cos}$, solche Modellparameter anpassen, die vorwiegend die Blindleistung beeinflussen. Dies ist bei der Massenträgheit J und der hydraulischen Impedanz $L_{hyd}$ der Fall, weshalb den Parameterreglern 12', 12" für diese Modellparameter in Figuren 6 und 7 die Korrektursignale $T_{D1cos}$ und $P_{D1cos}$ zugeführt werden. Es kommt auch hier nicht darauf an, welcher dieser Parameterregler 12', 12" das Korrektursignal $T_{D1cos}$ und welcher das Korrektursignal $P_{D1cos}$ erhält. Die Korrektursignalzuführung ist insoweit ebenfalls vertauschbar.

Versuche haben gezeigt, dass die folgende Zuordnung der Korrektursignale $T_{D1sin}$, $T_{D1cos}$, $P_{D1sin}$, $P_{D1cos}$, $T_{D0}$, $P_{D0}$ zu den Modellparametern vorteilhaft ist:

- $T_{D1sin}$ zur Anpassung des Modellparameters $R_{hyd}$
- $T_{D1cos}$ zur Anpassung des Modellparameters $L_{hyd}$
- $P_{D1sin}$ zur Anpassung des Modellparameters ct
- $P_{D1cos}$ zur Anpassung des Modellparameters J
- $T_{D0}$ zur Anpassung des Modellparameters $v_s$
- $P_{D0}$ zur Anpassung des Modellparameters $v_i$

Es sind jedoch auch andere Kombinationen möglich. Entsprechend dieser Zuordnung können die einzelnen Korrektursignale demjenigen Einzelparameterregler 12.1, 12.2, etc. zugeführt werden, der den entsprechend zugeordneten Modellparameter anpasst.

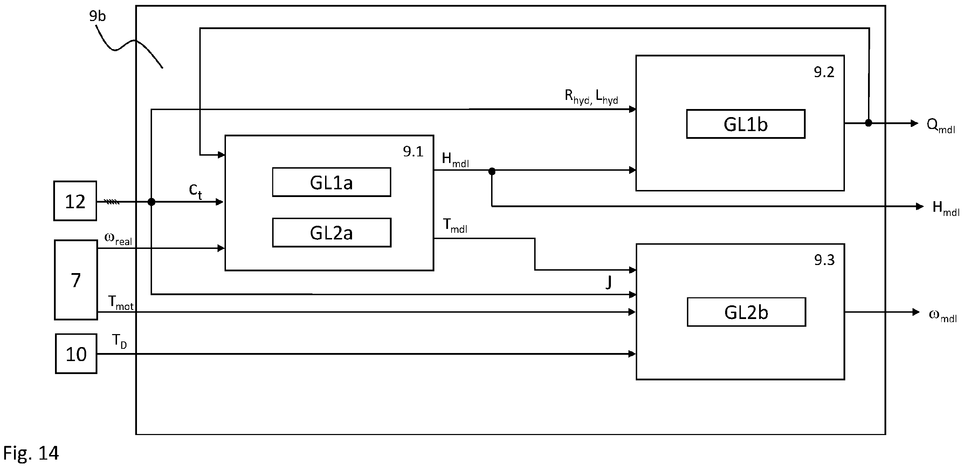

Die Ausgangssignale der Einzelparameterregler 12.1, 12.2, etc. d.h. die angepassten Modellparameter werden anschließend dem Pumpen-Motor-Modell 9b zur Verfügung gestellt, dessen Signalflussdiagramm Figur 14 zeigt. Das Pumpen-Motor-Modell 9b kann diese neuen Werte der Modellparameter dann für die Berechnung der Modelldrehzahl $\omega_{mod}$, des Förderstroms $Q_{mdl}$ und der Förderhöhe $H_{mdl}$ verwenden. Hierzu wird der Modellparameter ct dem ersten Funktionsblock 9.1, die beiden Modellparameter $R_{hyd}$ und $L_{hyd}$ dem zweiten Funktionsblock 9.2 und der Modellparameter J dem dritten Funktionsblock 9.3 zugeführt, innerhalb denen dann jeweils die neuen Modellparameterwerte in den entsprechenden Teilgleichungen GI1b, GI2a, GI2b verwendet werden.

Es sei darauf hingewiesen, dass die vorstehende Beschreibung lediglich beispielhaft zum Zwecke der Veranschaulichung gegeben ist und den Schutzbereich der Erfindung, der ausschließlich durch die beigefügten Ansprüche definiert wird, keineswegs einschränkt. Merkmale der Erfindung, die als "kann" "beispielhaft", "bevorzugt", "optional", "ideal", "vorteilhaft", "gegebenenfalls", "geeignet" oder dergleichen angegeben sind, sind als rein fakultativ zu betrachten und schränken ebenfalls den Schutzbereich nicht ein, welcher ausschließlich durch die Ansprüche festgelegt ist. Soweit in der vorstehenden Beschreibung Elemente, Komponenten, Verfahrensschritte, Werte oder Informationen genannt sind, die bekannte, naheliegende oder vorhersehbare Äquivalente besitzen, werden diese Äquivalente von der Erfindung mit umfasst. Ebenso schließt die Erfindung jegliche Änderungen, Abwandlungen oder Modifikationen von Ausführungsbeispielen ein, die den Austausch, die Hinzunahme, die Änderung oder das Weglassen von Elementen, Komponenten, Verfahrensschritte, Werten oder Informationen zum Gegenstand haben, solange der erfindungsgemäße Grundgedanke erhalten bleibt, ungeachtet dessen, ob die Änderung, Abwandlung oder Modifikationen zu einer Verbesserung oder Verschlechterung einer Ausführungsform führt.

Obgleich die vorstehende Erfindungsbeschreibung eine Vielzahl körperlicher, unkörperlicher oder verfahrensgegenständlicher Merkmale in Bezug zu einem oder mehreren konkreten Ausführungsbeispiel(en) nennt, so können diese Merkmale auch isoliert von dem konkreten Ausführungsbeispiel verwendet werden, jedenfalls soweit sie nicht das zwingende Vorhandensein weiterer Merkmale erfordern. Umgekehrt können diese in Bezug zu einem oder mehreren konkreten Ausführungsbeispiel(en) genannten Merkmale beliebig miteinander sowie mit weiteren offenbarten oder nicht offenbarten Merkmalen von gezeigten oder nicht gezeigten Ausführungsbeispielen kombiniert werden, jedenfalls soweit sich die Merkmale nicht gegenseitig ausschließen oder zu technischen Unvereinbarkeiten führen.

**Patentansprüche**

1. Verfahren zur Ermittlung des Förderstroms (Q) und/ oder der Förderhöhe (H) eines drehzahlgeregelten Kreiselpumpenaggregats (3, 4), indem eine Bezugsdrehzahl ($n_0$) oder ein Drehmoment des Kreiselpumpenaggregats (3, 4) mit einem periodischen Anregungssignal ($f_A(t)$) einer bestimmten Anregungsfrequenz ($\omega_A$) beaufschlagt wird, um eine modulierte Solldrehzahl ($n_{soll}$) zu erreichen, **gekennzeichnet durch** die Schritte:

   a. Bestimmung und Einstellung eines zur Erreichung der modulierten Solldrehzahl ($n_{soll}$) erforderlichen Drehmoments ($T_0$) oder Einstellung des modulierten Drehmoments,
   b. Bestimmung der Istdrehzahl ($\omega_{real}$) des Kreiselpumpenaggregats (3, 4),
   c. Berechnung einer Modelldrehzahl ($\omega_{mdl}$) mit Hilfe eines das Verhalten des Kreiselpumpenaggregats (3, 4) innerhalb eines hydraulischen Systems (1) nachbildenden, mathematischen Pumpen-Motor-Modells (9),
   d. Berechnung wenigstens eines Störungssignals ($T_D$, $P_D$) aus einer Abweichung der Modelldrehzahl ($\omega_{mdl}$) von der Istdrehzahl ($\omega_{real}$) des Kreiselpumpenaggregats (3, 4),
   e. Bestimmung wenigstens eines Korrektursignals ($T_{D1sin}$, $T_{D1cos}$, $P_{D1sin}$, $P_{D1cos}$) durch Integration des Produkts aus dem Störungssignal ($T_D$, $P_D$) und einem Sinus- oder Cosinussignal mit dem Einfachen oder einem Vielfachen der Anregungsfrequenz ($\omega_A$) über wenigstens eine Periode des Anregungssignals ($f_A(t)$),
   f. Anpassung wenigstens eines Modellparameters ($R_{hyd}$, J, $L_{hyd}$, ct) des Pumpen-Motor-Modells (9) in Abhängigkeit des Korrektursignals ($T_{D1sin}$, $T_{D1cos}$, $P_{D1sin}$, $P_{D1cos}$) und
   g. Berechnung des Förderstroms (Q) und/ oder der Förderhöhe (H) mit Hilfe des angepassten Pumpen-Motor-Modells (9).

2. Verfahren nach Anspruch 1, **dadurch gekennzeichnet, dass** das Pumpen-Motor-Modell (9) wenigstens eine erste Gleichung (GI1) in Integralform zur Berechnung des Förderstroms (Q) und eine zweite Gleichung (GI2) in Integralform zur Berechnung der Modelldrehzahl ($\omega_{mdl}$) umfasst, und diese beiden Gleichungen (GI1, GI2) wiederholt zyklisch ausgewertet werden.

3. Verfahren nach Anspruch 2, **dadurch gekennzeichnet, dass** die erste Gleichung in der folgenden Integralform verwendet wird:

$$\text{GI1:} \quad Q_{mdl} = \frac{1}{L_{hyd}} \int_0^t \left( (a\omega^2 - bQ_{mdl}\omega - cQ_{mdl}^2) - R_{hyd}Q_{mdl}^2 - H_{static} \right) dt$$

oder

$$\text{GI1:} \quad Q_{mdl}(k+1) = Q_{mdl}(k) + \frac{1}{L_{hyd}} \left( (a\omega^2(k) - bQ_{mdl}(k)\omega(k) - cQ_{mdl}^2(k)) - \right.$$

$$\left. R_{hyd}Q_{mdl}^2(k) - H_{static}(k) \right) \cdot \Delta t$$

wobei

$Q_{mdl}$ der Förderstrom der Kreiselpumpe,
$\omega$ eine Drehzahl bzw. Drehfrequenz der Kreiselpumpe ($\omega = 2\pi n$),
$a, b, c$ Parameter sind, die das hydraulische Pumpenkennfeld ($H(Q, \omega)$) anhand von Pumpenkurven beschreiben,
$R_{hyd}$ der hydraulische Widerstand des hydraulischen Systems,
$L_{hyd}$ die hydraulische Induktivität des hydraulischen Systems
$H_{static}$ eine geodätische Förderhöhe,
k ein diskreter Zeitpunkt und
$\Delta t$ das zeitliche Intervall zwischen einem Zeitpunkt k und dem nächsten Zeitpunkt k+1 ist.

4. Verfahren nach Anspruch 2 oder 3, **dadurch gekennzeichnet, dass** die erste Gleichung (Gl1) in Form der folgenden zwei Teilgleichungen (Gl1a, Glb) verwendet wird, die nacheinander wiederholt berechnet werden:

$$\text{Gl1a: } H_{mdl} = a\omega^2 - b\,Q_{mdl}\omega - cQ_{mdl}^2$$

$$\text{Gl1b: } Q_{mdl} = \frac{1}{L_{hyd}} \int_0^t \left( H_{mdl} - R_{hyd}Q_{mdl}^2 - H_{static} \right) dt$$

oder

$$\text{Gl1a: } H_{mdl}(k) = a\omega^2(k) - bQ_{mdl}(k)\omega(k) - cQ_{mdl}^2(k)$$

$$\text{Gl1b: } Q_{mdl}(k+1) = Q_{mdl}(k) + \frac{1}{L_{hyd}} \left( H_{mdl}(k) - R_{hyd}Q_{mdl}^2(k) - H_{static}(k) \right) \cdot \Delta t$$

wobei

$H_{mdl}$ die Förderhöhe der Kreiselpumpe ist.
$Q_{mdl}$ der Förderstrom der Kreiselpumpe,
$\omega$ eine Drehzahl bzw. Drehfrequenz der Kreiselpumpe ($\omega = 2\pi n$),
$a, b, c$ Parameter sind, die das hydraulische Pumpenkennfeld (H(Q, $\omega$)) anhand von Pumpenkurven beschreiben,
$R_{hyd}$ der hydraulische Widerstand des hydraulischen Systems,
$L_{hyd}$ die hydraulische Induktivität des hydraulischen Systems,
$H_{static}$ eine geodätische Förderhöhe
k ein diskreter Zeitpunkt und
$\Delta t$ das zeitliche Intervall zwischen einem Zeitpunkt k und dem nächsten Zeitpunkt k+1 ist.

5. Verfahren nach Anspruch 2, 3 oder 4, **dadurch gekennzeichnet, dass** die zweite Gleichung in der folgenden Integralform verwendet wird:

$$\text{Gl2: } \omega_{mdl} = \frac{1}{J} \int_0^t \left( T_{mot} - \left( a_t Q_{mdl}\omega - b_t Q_{mdl}^2 - c_t \frac{Q_{mdl}^3}{\omega} + v_i\omega^2 + v_s\omega - I\frac{dQ}{dt} \right) + T_D \right) dt$$

oder

$$\text{Gl2: } \omega_{mdl}(k+1) = \omega_{mdl}(k) + \frac{1}{J} \left( T_{mot}(k) - \left( a_t Q_{mdl}(k)\omega(k) - b_t Q_{mdl}^2(k) - c_t \frac{Q_{mdl}^3(k)}{\omega(k)} + v_i\omega^2(k) + v_s\omega(k) - I\frac{Q(k)-Q(k-1)}{\Delta t} \right) + T_D(k) \right) \cdot \Delta t$$

wobei

$T_{mot}$ das mechanische Drehmoment des Motors (Motormoment) der Kreiselpumpe,
$T_D$ das berechnete Störsignal in Form eines Moments (Störmoment),
$Q_{mdl}$ der Förderstrom der Kreiselpumpe,
$\omega_{mdl}$ die Modelldrehzahl bzw. Drehfrequenz der Kreiselpumpe ($\omega = 2\pi n$),
$\omega$ eine Drehzahl bzw. Drehfrequenz der Kreiselpumpe ($\omega = 2\pi n$),
$a_t, b_t, c_t$ Parameter sind, die das statische Drehmomentkennfeld (T(Q, $\omega$)) der Pumpe anhand von Drehmomentkurven beschreiben,
$v_i$ eine die Reibung zwischen Laufrad und Medium beschreibende Größe

$v_s$ eine die Lagerreibung beschreibende Größe

$J$ die Massenträgheit der rotierenden Komponenten der Kreiselpumpe (Laufrad, Welle, Rotor),

$I$ die Massenträgheit des Fördermediums im Laufrad,

k ein diskreter Zeitpunkt und

$\Delta t$ das zeitliche Intervall zwischen einem Zeitpunkt k und dem nächsten Zeitpunkt k+1 ist.

6. Verfahren nach einem der Ansprüche 2 bis 5, **dadurch gekennzeichnet, dass** die zweite Gleichung in Form der folgenden zwei Teilgleichungen (Gl2a, Gl2b) verwendet wird, die nacheinander, zyklisch wiederholt berechnet werden:

$$\text{Gl2a:} \quad T_{mdl} = a_t Q_{mdl}\omega - b_t Q_{mdl}^2 - c_t \frac{Q_{mdl}^3}{\omega} + v_i \omega^2 + v_s \omega - I\frac{\mathrm{d}Q}{\mathrm{d}t}$$

$$\text{Gl2b:} \quad \omega_{mdl} = \frac{1}{J}\int_0^t (T_{mot} - T_{mdl} + T_D)\, dt$$

oder

$$\text{Gl2a:} \quad T_{mdl}(k) = a_t Q_{mdl}(k)\omega(k) - b_t Q_{mdl}^2(k) - c_t \frac{Q_{mdl}^3(k)}{\omega(k)} + v_i \omega^2(k) + v_s \omega(k) -$$

$$I\frac{Q(k)-Q(k-1)}{\Delta t}$$

$$\text{Gl2b:} \quad \omega_{mdl}(k+1) = \omega_{mdl}(k) + \frac{1}{J}(T_{mot}(k) - T_{mdl}(k) + T_D(k)) \cdot \Delta t$$

wobei

$T_{mdl}$ ein Pumpendrehmoment der Kreiselpumpe

$T_{mot}$ das mechanische Drehmoment des Motors (Motormoment) der Kreiselpumpe,

$T_D$ das berechnete Störsignal in Form eines Moments (Störmoment),

$Q_{mdl}$ der Förderstrom der Kreiselpumpe,

$\omega_{mdl}$ die Modelldrehzahl bzw. Drehfrequenz der Kreiselpumpe ($\omega = 2\pi n$),

$\omega$ eine Drehzahl bzw. Drehfrequenz der Kreiselpumpe ($\omega = 2\pi n$),

$a_t, b_t, c_t$ Parameter sind, die das statische Drehmomentkennfeld ($T(Q, \omega)$) der Pumpe anhand von Drehmomentkurven beschreiben,

$v_i$ eine die Reibung zwischen Laufrad und Medium beschreibende Größe

$v_s$ eine die Lagerreibung beschreibende Größe

$J$ die Massenträgheit der rotierenden Komponenten der Kreiselpumpe (Laufrad, Welle, Rotor),

$I$ die Massenträgheit des Fördermediums im Laufrad ist,

k ein diskreter Zeitpunkt und

$\Delta t$ das zeitliche Intervall zwischen einem Zeitpunkt k und dem nächsten Zeitpunkt k+1 ist.

7. Verfahren nach einem der vorherigen Ansprüche, **dadurch gekennzeichnet, dass** die Differenz zwischen der Modelldrehzahl ($\omega_{mdl}$) und der Istdrehzahl ($\omega_{real}$) einem wenigstens einen Integralanteil enthaltenden Regler (15) zugeführt wird, wobei das Ausgangssignal dieses Reglers (15) das Störungssignal ($T_D$) bildet oder das Störungssignal ($P_D$) durch Multiplikation des Ausgangssignals dieses Reglers (15) mit der Istdrehzahl ($\omega_{real}$) gebildet wird.

8. Verfahren nach einem der vorherigen Ansprüche, **dadurch gekennzeichnet, dass** in Schritt d. ein erstes Störungssignal ($T_D$) und ein zweites Störungssignal ($P_D$) ermittelt werden, indem die Differenz zwischen der Modelldrehzahl ($\omega_{mdl}$) und der Istdrehzahl ($\omega_{real}$) einem wenigstens einen Integralanteil enthaltenden Regler (15) zugeführt wird, und das Ausgangssignal dieses Reglers (15) das erste Störungssignal ($T_D$) bildet und das zweite Störungssignal ($P_D$) durch Multiplikation des Ausgangssignals dieses Reglers (15) mit der Istdrehzahl ($\omega_{real}$) gebildet wird.

9. Verfahren nach einem der vorherigen Ansprüche, **dadurch gekennzeichnet, dass** aus dem Störungssignal ($T_D$, $P_D$) oder aus jedem der Störungssignale ($T_D$, $P_D$) zwei oder mehr Korrektursignale ($T_{D1sin}$, $T_{D1cos}$, $P_{D1sin}$, $P_{D1cos}$) bestimmt werden, und jedes Korrektursignal ($T_{D1sin}$, $T_{D1cos}$, $P_{D1sin}$, $P_{D1cos}$) zur Anpassung jeweils eines bestimmten Modellparameters ($R_{hyd}$, J, $L_{hyd}$, ct) des Pumpen-Motor-Modells (9) verwendet wird.

10. Verfahren nach einem der vorherigen Ansprüche, **dadurch gekennzeichnet, dass** der Modellparameter der hydraulische Widerstand ($R_{hyd}$) des Systems (1) oder der Parameter ct ist, und in Schritt e. dasjenige Sinus- oder Cosinussignal verwendet wird, das mit dem Anregungssignal ($f_A(t)$) in Phase liegt.

11. Verfahren zumindest nach Ansprüchen 8 und 10, **dadurch gekennzeichnet, dass** der hydraulische Widerstand ($R_{hyd}$) in Abhängigkeit eines ersten Korrektursignals ($P_{D1sin}$) angepasst wird, das aus dem zweiten Störungssignal ($P_D$) gebildet wird, und/ oder **dass** der Parameter ct in Abhängigkeit eines ersten Korrektursignals ($T_{D1sin}$) angepasst wird, das aus dem ersten Störungssignal ($T_D$) gebildet wird.

12. Verfahren nach einem der vorherigen Ansprüche, **dadurch gekennzeichnet, dass** der Modellparameter die Massenträgheit (J) des Kreiselpumpenaggregats (3, 4) oder die hydraulische Induktivität ($L_{hyd}$) des Systems (1) ist und in Schritt e. dasjenige Sinus- oder Cosinussignal verwendet wird, das zum Anregungssignal ($f_A(t)$) um 90° phasenverschoben liegt.

13. Verfahren zumindest nach Ansprüchen 8 und 12, **dadurch gekennzeichnet, dass** die Massenträgheit (J) des Kreiselpumpenaggregats (3, 4) in Abhängigkeit eines zweiten Korrektursignals ($P_{D1cos}$) angepasst wird, das aus dem zweiten Störungssignal ($P_D$) gebildet wird, und/ oder **dass** die hydraulische Induktivität ($L_{hyd}$) des Systems (1) in Abhängigkeit eines zweiten Korrektursignals ($T_{D1cos}$) angepasst wird, das aus dem ersten Störungssignal ($T_D$) gebildet wird.

14. Verfahren nach einem der vorherigen Ansprüche, **dadurch gekennzeichnet, dass** die Anpassung des Modellparameters ($R_{hyd}$, J, $L_{hyd}$, ct) unter Verwendung eines einen Integralanteil enthaltenden Reglers (17, 17a, 17b, 17c) erfolgt, dem das Korrektursignal ($T_{D1sin}$, $T_{D1cos}$, $P_{D1sin}$, $P_{D1cos}$) zugeführt wird, wobei das Reglerausgangssignal (K, $K_a$, $K_b$, $K_c$) mit einem Initialwert für den Modellparameter ($R_{hyd}$, J, $L_{hyd}$, ct) multipliziert wird, um den angepassten Modellparameter ($R_{hyd}$, J, $L_{hyd}$, $c_t$) zu erhalten.

15. Kreiselpumpenaggregat mit einer Kreiselpumpe (3), einem diese antreibenden Elektromotor und einer Steuerungselektronik (4) zur Steuerung und/ oder Regelung des Elektromotors, **dadurch gekennzeichnet, dass** die Steuerungselektronik (4) eingerichtet ist, das Verfahren nach einem der Ansprüche 1 bis 14 auszuführen.

**Claims**

1. Method for determining the flow rate (Q) and/or the pumping head (H) of a rotational-speed-controlled centrifugal pump assembly (3, 4), by applying a periodic excitation signal ($f_A(t)$) of a certain excitation frequency ($\omega_A$) to a reference rotational speed ($n_0$) or a torque of the centrifugal pump assembly (3, 4) in order to obtain a modulated nominal rotational speed ($n_{soll}$), **characterised by** the steps:

    a. determining and setting a torque ($T_0$) required to reach the modulated nominal rotational speed ($n_{soll}$) or setting the modulated torque,
    b. determining the current rotational speed ($\omega_{real}$) of the centrifugal pump assembly (3, 4),
    c. calculating a model rotational speed ($\omega_{mdl}$) with the help of a mathematical pump-motor model (9) emulating the behaviour of the centrifugal pump assembly (3, 4) within a hydraulic system (1),
    d. calculating at least one disturbance signal ($T_D$, $P_D$) from a deviation between the model rotational speed ($\omega_{mdl}$) and the current rotational speed ($\omega_{real}$) of the centrifugal pump assembly (3, 4),
    e. determining at least one correction signal ($T_{D1sin}$, $T_{D1cos}$, $P_{D1sin}$, $P_{D1cos}$) through the integration of the product of the disturbance signal ($T_D$, $P_D$) and a sine or cosine signal with the excitation frequency ($\omega_A$) or a multiple thereof over at least one period of the excitation signal ($f_A(t)$),
    f. adjusting at least one model parameter ($R_{hyd}$, J, $L_{hyd}$, $c_t$) of the pump-motor model (9) depending on the correction signal ($T_{D1sin}$, $T_{D1cos}$, $P_{D1sin}$, $P_{D1cos}$) and
    g. calculating the flow rate (Q) and/or the pumping head (H) with the help of the adjusted pump-motor model (9).

2. Method according to claim 1, **characterised by** the pump-motor model (9) comprising at least one first equation (GI1) in integral form for calculation of the flow rate (Q) and one second equation (GI2) in integral form for calculation of the model rotational speed ($\omega_{mdl}$), and by the repeated cyclical evaluation of these two equations (GI1, GI2).

3. Method according to claim 2, **characterised by** the first equation being used in the following integral form:

$$\text{GI1:}\quad Q_{mdl} = \frac{1}{L_{hyd}} \int_0^t \left( (a\omega^2 - bQ_{mdl}\omega - cQ_{mdl}^2) - R_{hyd}Q_{mdl}^2 - H_{static} \right) dt$$

or

$$\text{GI1:}\quad Q_{mdl}(k+1) = Q_{mdl}(k) + \frac{1}{L_{hyd}} \left( (a\omega^2(k) - bQ_{mdl}(k)\omega(k) - cQ_{mdl}^2(k)) - \right.$$

$$\left. R_{hyd}Q_{mdl}^2(k) - H_{static}(k) \right) \cdot \Delta t$$

where

$Q_{mdl}$ is the flow rate of the centrifugal pump,
$\omega$ is a rotational speed or rotational frequency of the centrifugal pump ($\omega$) = $2\pi n$),
*a, b, c* care parameters that describe the hydraulic pump performance map (H(Q, $\omega$)) based on pump curves,
$R_{hyd}$ is the hydraulic resistance of the hydraulic system,
$L_{hyd}$ is the hydraulic inductance of the hydraulic system,
$H_{static}$ is a geodetic pumping head,
k is a discrete point in time and
$\Delta t$ is the time interval between a point in time k and the next point in time k+1.

4. Method according to claim 2 or 3, **characterised by** the first equation (GI1) being used in the form of the two following partial equations (GI1a, GI1b) that are repeatedly calculated sequentially:

$$\text{GI1a:}\quad H_{mdl} = a\omega^2 - b\, Q_{mdl}\omega - cQ_{mdl}^2$$

$$\text{GI1b:}\quad Q_{mdl} = \frac{1}{L_{hyd}} \int_0^t \left( H_{mdl} - R_{hyd}Q_{mdl}^2 - H_{static} \right) dt$$

or

$$\text{GI1a:}\quad H_{mdl}(k) = a\omega^2(k) - bQ_{mdl}(k)\omega(k) - cQ_{mdl}^2(k)$$

$$\text{GI1b:}\quad Q_{mdl}(k+1) = Q_{mdl}(k) + \frac{1}{L_{hyd}} \left( H_{mdl}(k) - R_{hyd}Q_{mdl}^2(k) - H_{static}(k) \right) \cdot \Delta t$$

where

$H_{mdl}$ is the pumping head of the centrifugal pump,
$Q_{mdl}$ is the flow rate of the centrifugal pump,
$\omega$ is a rotational speed or rotational frequency of the centrifugal pump ($\omega$ = $2\pi n$),
*a, b, c* care parameters that describe the hydraulic pump performance map (H(Q, $\omega$)) based on pump curves,
$R_{hyd}$ is the hydraulic resistance of the hydraulic system,
$L_{hyd}$ is the hydraulic inductance of the hydraulic system,
$H_{static}$ is a geodetic pumping head,
k is a discrete point in time and
$\Delta t$ is the time interval between a point in time k and the next point in time k+1.

5. Method according to claim 2, 3 or 4, **characterised by** the second equation being used in the following integral form:

$$\text{Gl2:} \quad \omega_{mdl} = \frac{1}{J}\int_0^t \left(T_{mot} - \left(a_t Q_{mdl}\omega - b_t Q_{mdl}^2 - c_t \frac{Q_{mdl}^3}{\omega} + v_i\omega^2 + v_s\omega - I\frac{dQ}{dt}\right) + T_D\right)dt$$

or

$$\text{Gl2:} \quad \omega_{mdl}(k+1) = \omega_{mdl}(k) + \frac{1}{J}\left(T_{mot}(k) - \left(a_t Q_{mdl}(k)\omega(k) - b_t Q_{mdl}^2(k) - c_t\frac{Q_{mdl}^3(k)}{\omega(k)} + v_i\omega^2(k) + v_s\omega(k) - I\frac{Q(k)-Q(k-1)}{\Delta t}\right) + T_D(k)\right)\cdot\Delta t$$

where

$T_{mot}$ is the mechanical torque of the motor (motor moment) of the centrifugal pump,
$T_D$ is the calculated disturbance signal in torque form (disturbance torque),
$Q_{mdl}$ is the flow rate of the centrifugal pump,
$\omega_{mdl}$ is the model rotational speed or rotational frequency of the centrifugal pump ($\omega = 2\pi n$),
$\omega$ is a rotational speed or rotational frequency of the centrifugal pump ($\omega = 2\pi n$),
$a_t$, $b_t$, $c_t$ are parameters that describe the static torque map ($T(Q, \omega)$) of the pump based on torque curves,
$v_i$ is a value describing the friction between the impeller and medium,
$v_s$ is a value describing the bearing friction,
$J$ is the mass inertia of the centrifugal pump's rotating components (impeller, shaft, rotor),
$I$ is the mass inertia of the conveying medium in the impeller,
k is a discrete point in time and
$\Delta t$ is the time interval between a point in time k and the next point in time k+1.

6. Method according to claims 2 through 5, **characterised by** the second equation being used in the form of the two following partial equations (Gl2a, Gl2b) that are repeatedly calculated cyclically and sequentially:

$$\text{Gl2a:} \quad T_{mdl} = a_t Q_{mdl}\omega - b_t Q_{mdl}^2 - c_t\frac{Q_{mdl}^3}{\omega} + v_i\omega^2 + v_s\omega - I\frac{dQ}{dt}$$

$$\text{Gl2b:} \quad \omega_{mdl} = \frac{1}{J}\int_0^t (T_{mot} - T_{mdl} + T_D)\,dt$$

or

$$\text{Gl2a:} \quad T_{mdl}(k) = a_t Q_{mdl}(k)\omega(k) - b_t Q_{mdl}^2(k) - c_t\frac{Q_{mdl}^3(k)}{\omega(k)} + v_i\omega^2(k) + v_s\omega(k) - I\frac{Q(k)-Q(k-1)}{\Delta t}$$

$$\text{Gl2b:} \quad \omega_{mdl}(k+1) = \omega_{mdl}(k) + \frac{1}{J}(T_{mot}(k) - T_{mdl}(k) + T_D(k))\cdot\Delta t$$

where

$T_{mdl}$ is a pump torque of the centrifugal pump,
$T_{mot}$ is the mechanical torque of the motor (motor moment) of the centrifugal pump,

$T_D$ is the calculated disturbance signal in torque form (disturbance torque),

$Q_{mdl}$ is the flow rate of the centrifugal pump,

$\omega_{mdl}$ is the model rotational speed or rotational frequency of the centrifugal pump ($\omega = 2\pi n$),

$\omega$ is a rotational speed or rotational frequency of the centrifugal pump ($\omega = 2\pi n$),

$at, br, ct$ are parameters that describe the static torque map ($T(Q, \omega)$) of the pump based on torque curves,

$v_i$ is a value describing the friction between the impeller and medium,

$v_s$ is a value describing the bearing friction,

$J$ is the mass inertia of the centrifugal pump's rotating components (impeller, shaft, rotor),

$I$ is the mass inertia of the conveying medium in the impeller,

k is a discrete point in time and

$\Delta$t is the time interval between a point in time k and the next point in time k+1.

7. Method according to one of the preceding claims, **characterised by** the difference between the model rotational speed $\omega_{mdl}$) and the current rotational speed ($\omega_{real}$) being supplied to a control unit (15) comprising at least one integral component, in which the output signal of this control unit (15) forms the disturbance signal ($T_D$) or the disturbance signal ($P_D$) is formed by multiplying the output signal of this control unit (15) by the current rotational speed ($\omega_{real}$).

8. Method according to one of the preceding claims, **characterised by** a first disturbance signal ($T_D$) and a second disturbance signal ($P_D$) being determined in step d. by supplying the difference between the model rotational speed $\omega_{mdl}$) and the current rotational speed ($\omega_{real}$) to a control unit (15) comprising at least one integral component, and the output signal of this control unit (15) forming the first disturbance signal($T_D$) and the second disturbance signal($P_D$) being formed by multiplying the output signal of this control unit (15) by the current rotational speed ($\omega_{real}$).

9. Method according to one of the preceding claims, **characterised by** two or more correction signals ($T_{D1sin}$, $T_{D1cos}$, $P_{D1sin}$, $P_{D1cos}$) being determined from the disturbance signal ($T_D$, $P_D$) or from each of the disturbance signals ($T_D$, $P_D$) and each correction signal ($T_{D1sin}$, $T_{D1cos}$, $P_{D1sin}$, $P_{D1cos}$) being used to adjust respectively one specific model parameter ($R_{hyd}$, J, $L_{hyd}$, $c_t$) of the pump-motor model (9).

10. Method according to one of the preceding claims, **characterised by** the model parameter being the hydraulic resistance ($R_{hyd}$) of the system (1) or the parameter $c_t$, and by the sine or cosine signal that is in phase with the excitation signal ($f_A(t)$) being used in step e.

11. Method according to at least claims 8 and 10, **characterised by** the hydraulic resistance ($R_{hyd}$) being adjusted depending on a first correction signal ($P_{D1sin}$) that is formed from the second disturbance signal ($P_D$) and/or the parameter $c_t$ being adjusted depending on a first correction signal ($T_{D1sin}$) that is formed from the first disturbance signal ($T_D$).

12. Method according to one of the preceding claims, **characterised by** the model parameter being the mass inertia (J) of the centrifugal pump assembly (3, 4) or the hydraulic inductance ($L_{hyd}$) of the system (1), and by the sine or cosine signal that is phase shifted by 90° to the excitation signal ($f_A(t)$) being used in step e.

13. Method according to at least claims 8 and 12, **characterised by** the mass inertia (J) of the centrifugal pump assembly (3, 4) being adjusted depending on a second correction signal ($P_{D1cos}$) that is formed from the second disturbance signal ($P_D$) and/or the hydraulic inductance ($L_{hyd}$) of the system (1) being adjusted depending on a second correction signal ($T_{D1cos}$) that is formed from the first disturbance signal ($T_D$).

14. Method according to one of the preceding claims, **characterised by** the model parameter ($R_{hyd}$, J, $L_{hyd}$, $c_t$) being adjusted using a control unit (17, 17a, 17b, 17c) comprising an integral component, which is supplied with the correction signal ($T_{D1sin}$, $T_{D1cos}$, $P_{D1sin}$, $P_{D1cos}$), in which the output signal of the control unit (K, $K_a$, $K_b$, $K_c$) is multiplied by an initial value for the model parameter ($R_{hyd}$, J, $L_{hyd}$, $c_t$) in order to obtain the adjusted model parameter ($R_{hyd}$, J, $L_{hyd}$, $c_t$).

15. Centrifugal pump assembly with a centrifugal pump (3), an electric motor driving the same and control electronics (4) for the closed-loop and/or openloop control of the electric motor, **characterised by** the control electronics (4) being configured to execute one of the claims 1 through 14.

**Revendications**

1. Procédé pour déterminer le débit (Q) et/ou la hauteur de refoulement (H) d'un groupe motopompe centrifuge (3, 4) à vitesse de rotation régulée, en appliquant à une vitesse de rotation de référence ($n_0$) ou à un couple de rotation du groupe motopompe centrifuge (3, 4) un signal d'excitation périodique ($f_A(t)$) d'une fréquence d'excitation déterminée ($\omega_A$), afin d'atteindre une vitesse de rotation nominale modulée ($n_{soll}$), **caractérisé par** les étapes :

   a. Détermination et réglage d'un couple ($T_0$) nécessaire pour atteindre la vitesse de rotation nominale modulée ($n_{soll}$) ou réglage du couple modulé,
   b. Détermination de la vitesse de rotation effective ($\omega_{real}$) du groupe motopompe centrifuge (3, 4),
   c. Calcul d'une vitesse de rotation modèle $\omega_{mdl}$) avec un modèle mathématique pompe-moteur (9) reproduisant le comportement du groupe motopompe centrifuge (3, 4) au sein d'un système hydraulique (1),
   d. Calcul d'au moins un signal de défaut ($T_D$, $P_D$) à partir d'un écart entre la vitesse de rotation du modèle ($\omega_{mdl}$) et la vitesse de rotation effective ($\omega_{real}$) du groupe motopompe centrifuge (3, 4),
   e. Détermination d'au moins un signal de correction ($T_{D1sin}$, $T_{D1cos}$, $P_{D1sin}$, $P_{D1cos}$) par intégration du produit du signal de défaut ($T_D$, $P_D$) et d'un signal sinusoïdal ou cosinusoïdal avec la fréquence d'excitation ($\omega_A$) ou un multiple de celle-ci sur au moins une période du signal d'excitation ($f_A(t)$),
   f. Adaptation d'au moins un paramètre de modèle ($R_{hyd}$, J, $L_{hyd}$, $c_t$) du modèle pompe-moteur (9) en fonction du signal de correction ($T_{D1sin}$, $T_{D1cos}$, $P_{D1sin}$, $P_{D1cos}$) et
   g. Calcul du débit (Q) et/ou de la hauteur de refoulement (H) avec le modèle pompe-moteur adapté (9).

2. Procédé selon la revendication 1, **caractérisé en ce que** le modèle pompe-moteur (9) comprend au moins une première équation (GI1) sous forme intégrale pour le calcul du débit de refoulement (Q) et une seconde équation (GI2) sous forme intégrale pour le calcul de la vitesse de rotation du modèle ($\omega_{mdl}$), et que ces deux équations (GI1, GI2) sont évaluées de manière cyclique et répétée.

3. Procédé selon la revendication 2, **caractérisé en ce que** la première équation est utilisée sous la forme intégrale suivante :

$$GI1 : \quad Q_{mdl} = \frac{1}{L_{hyd}} \int_0^t \left( (a\omega^2 - bQ_{mdl}\omega - cQ_{mdl}^2) - R_{hyd}Q_{mdl}^2 - H_{static} \right) dt$$

ou

$$GI1 : \quad Q_{mdl}(k+1) = Q_{mdl}(k) + \frac{1}{L_{hyd}} \left( (a\omega^2(k) - bQ_{mdl}(k)\omega(k) - cQ_{mdl}^2(k)) - \right.$$
$$\left. R_{hyd}Q_{mdl}^2(k) - H_{static}(k) \right) \cdot \Delta t$$

sachant que

   $Q_{mdl}$ = Débit de la pompe centrifuge,
   $\omega$ une vitesse de rotation ou une fréquence de rotation de la pompe centrifuge ($\omega = 2\pi n$),
   *a, b, c* = Paramètres décrivant les caractéristiques hydrauliques de la pompe (H(Q, $\omega$)) avec des courbes de pompage,
   $R_{hyd}$ = Résistance hydraulique du système hydraulique,
   $L_{hyd}$ = Inductance hydraulique du système hydraulique
   $H_{static}$ = Hauteur de refoulement géodésique,
   k = Moment discret et
   $\Delta t$ = Intervalle de temps entre un moment k et le moment suivant k+1.

4. Procédé selon la revendication 2 ou 3, **caractérisé en ce que** la première équation (GI1) est utilisée sous la forme des deux équations partielles suivantes (GI1a, GI1b), calculées successivement et de manière répétée :

$$GI1a : H_{mdl} = a\omega^2 - b\,Q_{mdl}\omega - cQ_{mdl}^2$$

$$\text{GI1b}: Q_{mdl} = \frac{1}{L_{hyd}} \int_0^t \left( H_{mdl} - R_{hyd} Q_{mdl}^2 - H_{static} \right) dt$$

ou

$$\text{GI1a}: H_{mdl}(k) = a\omega^2(k) - bQ_{mdl}(k)\omega(k) - cQ_{mdl}^2(k)$$

$$\text{GI1b}: Q_{mdl}(k+1) = Q_{mdl}(k) + \frac{1}{L_{hyd}} \left( H_{mdl}(k) - R_{hyd} Q_{mdl}^2(k) - H_{static}(k) \right) \cdot \Delta t$$

sachant que

$H_{mdl}$ = Hauteur de refoulement de la pompe centrifuge.
$Q_{mdl}$ = Débit de la pompe centrifuge,
$\omega$ une vitesse de rotation ou une fréquence de rotation de la pompe centrifuge ($\omega$ = $2\pi n$),
$a, b, c$ = Paramètres décrivant les caractéristiques hydrauliques de la pompe (H(Q, $\omega$)) avec des courbes de pompage,
$R_{hyd}$ = Résistance hydraulique du système hydraulique,
$L_{hyd}$ = Inductance hydraulique du système hydraulique,
$H_{static}$ = Hauteur de refoulement géodésique
$k$ = Moment discret et
$\Delta t$ = Intervalle de temps entre un moment k et le moment suivant k+1.

5.  Procédé selon les revendication 2, 3 ou 4, **caractérisé en ce que** la seconde équation est utilisée sous la forme intégrale suivante :

$$\text{GI2}: \quad \omega_{mdl} = \frac{1}{J} \int_0^t \left( T_{mot} - \left( a_t Q_{mdl}\omega - b_t Q_{mdl}^2 - c_t \frac{Q_{mdl}^3}{\omega} + v_i \omega^2 + v_s \omega - I \frac{dQ}{dt} \right) + T_D \right) dt$$

ou

$$\text{GI2}: \quad \omega_{mdl}(k+1) = \omega_{mdl}(k) + \frac{1}{J} \Big( T_{mot}(k) - \Big( a_t Q_{mdl}(k)\omega(k) - b_t Q_{mdl}^2(k) - c_t \frac{Q_{mdl}^3(k)}{\omega(k)} + v_i \omega^2(k) + v_s \omega(k) - I \frac{Q(k)-Q(k-1)}{\Delta t} \Big) + T_D(k) \Big) \cdot \Delta t$$

sachant que

$T_{mot}$ = Couple mécanique du moteur (couple du moteur) de la pompe centrifuge,
$T_D$ = Signal de défaut calculé sous la forme d'un couple (couple de défaut),
$Q_{mdl}$ = Débit de la pompe centrifuge,
$\omega_{mdl}$ la vitesse de rotation du modèle ou la fréquence de rotation de la pompe centrifuge ($\omega$ = $2\pi n$),
$\omega$ une vitesse de rotation ou une fréquence de rotation de la pompe centrifuge ($\omega$ = $2\pi n$),
$a_r, b_t, c_t$ = Paramètres décrivant la caractéristique de couple statique (T(Q, $\omega$)) de la pompe avec des courbes de couple,
$v_i$ = Grandeur décrivant le frottement entre la roue et le fluide
$v_s$ = Grandeur décrivant le frottement des roulements
$J$ = Inertie de masse des composants rotatifs de la pompe centrifuge (roue, arbre, rotor),
$I$ = Inertie de masse du liquide pompé dans la roue,
k = Moment discret et
$\Delta t$ = Intervalle de temps entre un moment k et le moment suivant k+1.

6. Procédé selon l'une des revendications 2 à 5, **caractérisé en ce que** la seconde équation est utilisée sous la forme des deux équations partielles suivantes (GI2a, GI2b), calculées successivement et de manière cyclique :

$$\text{GI2a} : T_{mdl} = a_t Q_{mdl}\omega - b_t Q_{mdl}^2 - c_t \frac{Q_{mdl}^3}{\omega} + v_i \omega^2 + v_s \omega - I \frac{dQ}{dt}$$

$$\text{GI2b} : \omega_{mdl} = \frac{1}{J} \int_0^t (T_{mot} - T_{mdl} + T_D)\, dt$$

ou

$$\text{GI2a} : T_{mdl}(k) = a_t Q_{mdl}(k)\omega(k) - b_t Q_{mdl}^2(k) - c_t \frac{Q_{mdl}^3(k)}{\omega(k)} + v_i \omega^2(k) + v_s \omega(k) -$$
$$I \frac{Q(k) - Q(k-1)}{\Delta t}$$

$$\text{GI2b} : \omega_{mdl}(k+1) = \omega_{mdl}(k) + \frac{1}{J}(T_{mot}(k) - T_{mdl}(k) + T_D(k)) \cdot \Delta t$$

sachant que

$T_{mdL}$ = Couple de pompage de la pompe centrifuge
$T_{mot}$ = Couple mécanique du moteur (couple du moteur) de la pompe centrifuge,
$T_D$ = Signal de défaut calculé sous la forme d'un couple (couple de défaut),
$Q_{mdl}$ = Débit de la pompe centrifuge,
$\omega_{mdl}$ la vitesse de rotation du modèle ou la fréquence de rotation de la pompe centrifuge ($\omega = 2\pi n$),
$\omega$ une vitesse de rotation ou une fréquence de rotation de la pompe centrifuge ($\omega = 2\pi n$),
$a_r, b_t, c_t$ = Paramètres décrivant la caractéristique de couple statique (T(Q, $\omega$)) de la pompe avec des courbes de couple,
$v_i$ = Grandeur décrivant le frottement entre la roue et le fluide
$v_s$ = Grandeur décrivant le frottement des roulements
$J$ = Inertie de masse des composants rotatifs de la pompe centrifuge (roue, arbre, rotor),
$I$ = Inertie de masse du liquide pompé dans la roue,
k = Moment discret et
$\Delta t$ = Intervalle de temps entre un moment k et le moment suivant k+1.

7. Procédé selon l'une des revendications précédentes, **caractérisé en ce que** la différence entre la vitesse de rotation du modèle ($\omega_{mdl}$) et la vitesse de rotation effective ($\omega_{real}$) est envoyée à un régulateur (15) contenant au moins une composante intégrale, sachant que le signal de sortie de ce régulateur (15) forme le signal de défaut ($T_D$) ou que le signal de défaut ($P_D$) est formé par multiplication du signal de sortie de ce régulateur (15) par la vitesse de rotation effective ($\omega_{real}$).

8. Procédé selon l'une des revendications précédentes, **caractérisé en ce qu'**à l'étape d., un premier signal de défaut ($T_D$) et un second signal de défaut ($P_D$) sont déterminés en amenant la différence entre la vitesse de rotation du modèle ($\omega_{mdl}$) et la vitesse de rotation effective ($\omega_{real}$) à un régulateur (15) contenant au moins une composante intégrale, et le signal de sortie de ce régulateur (15) forme le premier signal de défaut ($T_D$) et le second signal de défaut ($P_D$) est formé par multiplication du signal de sortie de ce régulateur (15) par la vitesse de rotation effective ($\omega_{real}$).

9. Procédé selon l'une quelconque des revendications précédentes, **caractérisé en ce que** deux signaux de correction ($T_{D1sin}$, $T_{D1cos}$, $P_{D1sin}$, $P_{D1cos}$) ou plus sont déterminés à partir du signal de défaut ($T_D$, $P_D$) ou à partir de chacun des signaux de défaut ($T_D$, $P_D$), et chaque signal de correction ($T_{D1sin}$, $T_{D1cos}$, $P_{D1sin}$, $P_{D1cos}$) sert à adapter respectivement un paramètre de modèle déterminé ($R_{hyd}$, J, $L_{hyd}$, $c_t$) du modèle pompe-moteur (9).

10. Procédé selon l'une des revendications précédentes, **caractérisé en ce que** le paramètre de modèle est la résistance hydraulique ($R_{hyd}$) du système (1) ou le paramètre $c_t$, et **en ce que** l'on utilise à l'étape e. le signal sinusoïdal ou cosinusoïdal en phase avec le signal d'excitation ($f_A(t)$).

**11.** Procédé au moins selon les revendications 8 et 10, **caractérisé en ce que** la résistance hydraulique ($R_{hyd}$) est adaptée en fonction d'un premier signal de correction ($P_{D1sin}$) formé à partir du second signal de défaut ($P_D$) et/ou **en ce que** le paramètre et est adapté en fonction d'un premier signal de correction ($T_{D1sin}$) formé à partir du premier signal de défaut ($T_D$).

**12.** Procédé selon l'une des revendications précédentes, **caractérisé en ce que** le paramètre de modèle est l'inertie de masse (J) du groupe motopompe centrifuge (3, 4) ou l'inductance hydraulique ($L_{hyd}$) du système (1) et **en ce que** l'on utilise à l'étape e. le signal sinusoïdal ou cosinusoïdal déphasé de 90° par rapport au signal d'excitation ($f_A(t)$).

**13.** Procédé au moins selon les revendications 8 et 12, **caractérisé en ce que** l'inertie de masse (J) du groupe motopompe centrifuge (3, 4) est adaptée en fonction d'un second signal de correction ($P_{D1cos}$) formé à partir du second signal de défaut ($P_D$), et/ou **en ce que** l'inductance hydraulique ($L_{hyd}$) du système (1) est adaptée en fonction d'un second signal de correction ($T_{D1cos}$) formé à partir du premier signal de défaut ($T_D$).

**14.** Procédé selon l'une des revendications précédentes, **caractérisé en ce que** l'adaptation du paramètre de modèle ($R_{hyd}$, J, $L_{hyd}$, $c_t$) est effectuée en utilisant un régulateur (17, 17a, 17b, 17c) contenant une partie intégrale, auquel le signal de correction ($T_{D1sin}$, $T_{D1cos}$, $P_{D1sin}$, $P_{D1cos}$), le signal de sortie du régulateur (K, $K_a$, $K_b$, $K_c$) étant multiplié par une valeur initiale pour le paramètre de modèle ($R_{hyd}$, J, $L_{hyd}$, $c_t$) afin d'obtenir le paramètre de modèle ajusté ($R_{hyd}$, J, $L_{hyd}$, $c_t$).

**15.** Groupe motopompe centrifuge comprenant une pompe centrifuge (3), un moteur électrique entraînant celle-ci et une électronique de commande (4) pour la commande et/ou la régulation du moteur électrique, **caractérisé en ce que** l'électronique de commande (4) est conçue pour exécuter le procédé selon l'une des revendications 1 à 14.

Fig. 1

Fig. 2

Fig. 3

$\omega_{real}$

$\omega_{mdl}$

14

15

PID

$T_D$

10

Fig. 4

$T_{D1sin}$

17 18 19 20

PID K

$R_{hyd}$

12

Fig. 5

$P_{D1cos}$

17a 18a 19a

PID $K_a$

J

12'

Fig. 6

$T_{D1cos}$

17b 18b 19b

PID $K_b$

$L_{hyd}$

12''

Fig. 7

$P_{D1sin}$

17c 18c 19c

PID $K_c$

$c_t$

12'''

Fig. 8

Fig. 9

Fig. 10

Fig. 11

I

II

III

IV

V

VI

$n_0$

$f_A(t)$

6

7

$T_{mot}$

$\omega_{real}$

9b

$Q_{mdl}$

$H_{mdl}$

$\omega_{mdl}$

10

$T_D$

$R_{hyd}$

11a

11.1

11.2

12a

12.1

12.2

$R_{hyd}$, J, $c_t$, $L_{hyd}$

$T_{D1sin}$ $T_{D1cos}$ $P_{D1sin}$ $P_{D1cos}$ $\cdots$

13

Fig. 13

Fig. 12

EP 4 198 317 B1

Fig. 14

EP 4 198 317 B1

38

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102014004336 A1
- US 2017184429 A1
- DE 102014016421 A1
- DE 102016208211 A1